# EUROPEAN PATENT APPLICATION

(11) **EP 4 750 260 A2**
(43) Date of publication of application: **27.05.2026**
(21) Application number: 25213416.8
(22) Date of filing: 04.11.2025
(51) Int. Cl.: H10D 84/01, H10D 84/83, H10D 84/03, H10B 43/40, H10B 80/00, H10D 89/10

(54) **SEMICONDUCTOR DEVICE AND ELECTRONIC SYSTEM INCLUDING THE SAME**

(30) Priority: 04.11.2024 KR 20240154177
(71) Applicant: Samsung Electronics Co., Ltd., Suwon-si, Gyeonggi-do 16677 (KR)
(72) Inventor: KIM, Dong Kyu, 16677 Suwon-si (KR); OH, Jun Seok, 16677 Suwon-si (KR); LEE, Sea Hoon, 16677 Suwon-si (KR); CHANG, Seong Pil, 16677 Suwon-si (KR)
(74) Representative: Marks & Clerk LLP

(57) **Abstract**

A semiconductor device may include an element isolation film on a substrate, a first gate electrode, and an auxiliary electrode on the element isolation film. The element isolation film may define a first active area of the substrate. A first source/drain area and a second source/drain area of a first conductivity type may be in the first active area. The second source/drain area may be spaced apart from the first source/drain area in a first direction. The first gate electrode may be on a portion of the first active area between the first source/drain area and the second source/drain area. The first gate electrode may extend in a second direction crossing the first direction. The substrate may include an impurity area surrounding the element isolation film. The impurity area may contain a second conductivity type impurity. The auxiliary electrode and the impurity area may be electrically connected to each other.

## Description

### FIELD

The present disclosure relates to a semiconductor device and/or an electronic system including the same. More specifically, the present disclosure relates to a semiconductor device including memory cells arranged three-dimensionally and/or an electronic system including the same.

### BACKGROUND

As an electronic product becomes lighter, thinner, and simpler, the demand for high integration of a semiconductor device is increasing. As the semiconductor device becomes more highly integrated, sizes of components in the semiconductor device (for example, a transistor) may further decrease, thereby causing leakage current. Therefore, there is a need to control the leakage current of the semiconductor device to improve performance and/or reliability of the semiconductor device.

In an electronic system that requires data storage, a semiconductor device that may store high-capacity data therein may be required. Accordingly, a scheme to increase the data storage capacity of the semiconductor device is being studied. For example, in one approach to increase the data storage capacity of the semiconductor device, a semiconductor device including three-dimensionally arranged memory cells instead of two-dimensionally arranged memory cells has been proposed.

### SUMMARY

The present disclosure relates to a semiconductor device with improved performance and reliability.

The present disclosure relates to an electronic system including a semiconductor device with improved performance and reliability.

Aspects of the present disclosure are not limited to the aspects mentioned above, and other aspects not mentioned may be clearly understood by those skilled in the art from descriptions as set forth below.

According to an embodiment of the present disclosure, a semiconductor device may include a substrate; an element isolation film on the substrate, the element isolation film defining a first active area of the substrate, the first active area of the substrate including a first source/drain area and a second source/drain area in the first active area, the first source/drain area contacting the element isolation film in a first direction and having a first conductivity type, the second source/drain area being spaced apart from the first source/drain area in the first direction and having the first conductivity type; a first gate electrode on a portion of the first active area between the first source/drain area and the second source/drain area, wherein the first gate electrode extends in a second direction and the second direction intersects the first direction, for example wherein the second direction is different, and optionally also orthogonal to, the first direction; a second gate electrode on the first active area and extending in the second direction, wherein the second source/drain area is between the first gate electrode and the second gate electrode; and a first auxiliary electrode disposed on the element isolation film. In a plan view, the first auxiliary electrode may not overlap the first source/drain area in the second direction and the first auxiliary electrode may overlap the second source/drain area in the second direction.

According to an embodiment of the present disclosure, a semiconductor device may include a substrate; an element isolation film on the substrate, the element isolation film defining a first active area of the substrate, the first active area of the substrate including a first source/drain area and a second source/drain area in the first active area, the first source/drain area having a first conductivity type, the second source/drain area being spaced apart from the first source/drain area in a first direction and having the first conductivity type; a first gate electrode on a portion of the first active area between the first source/drain area and the second source/drain area, wherein the first gate electrode extends in a second direction and the second direction intersects the first direction, for example wherein the second direction is different, and optionally also orthogonal, to the first direction; an auxiliary electrode on the element isolation film. The substrate may include an impurity area surrounding the element isolation film. The impurity area may contain an impurity having a second conductivity type. The second conductivity type may be different from the first conductivity type, and the auxiliary electrode and the impurity area may be electrically connected to each other.

According to an embodiment of the present disclosure, an electronic system may include a main substrate; a semiconductor device on the main substrate, the semiconductor device including a first substrate having a peripheral circuit area and a second substrate having a cell area; and a main controller on the main substrate and electrically connected to the semiconductor device. The semiconductor device may include an element isolation film on the first substrate, a first gate electrode, a second gate electrode, an auxiliary electrode on the element isolation film, a plurality of word-lines sequentially stacked on the second substrate, and a channel structure on the second substrate and intersecting the plurality of word-lines, and a bit-line contacting the channel structure. The element isolation film may define a first active area in the substrate. The first active area may include a first source/drain area and a second source/drain area. The first source/drain area may contact the element isolation film in a first direction and may have a first conductivity type. The second source/drain area may be spaced apart from the first source/drain area in the first direction and may have the first conductivity type. The first gate electrode may be on a portion of the first active area between the first source/drain area and the second source/drain area. The first gate electrode may extend in a second direction and the second direction may intersect the first direction, for example wherein the second direction is different, and optionally also orthogonal, to the first direction. The second gate electrode may be on the first active area and may extend in the second direction. The second source/drain area may be between the first gate electrode and the second gate electrode. In a plan view, the auxiliary electrode may not overlap the first source/drain area in the second direction and the auxiliary electrode may overlap the second source/drain area in the second direction.

According to an embodiment of the present disclosure, a method of manufacturing a semiconductor device may include providing a substrate including a trench, the trench defining a first active area of the substrate; forming an element isolation film on the substrate, the element isolation film exposing the first active area of the substrate; forming a plurality of electrodes on the substrate, the plurality of electrodes including a first auxiliary electrode on the element isolation film, a first gate electrode, and a second gate electrode; and forming impurities in the substrate, wherein forming impurities in the substrate may include forming a first source/drain area and a second source/drain area in the first active area, the first source/drain area may contact the element isolation film in a first direction and may have a first conductivity type, the second source/drain area may be spaced apart from the first source/drain area in the first direction and may have the first conductivity type, the first gate electrode may be on a portion of the first active area between the first source/drain area and the second source/drain area, the first gate electrode and the second gate electrode may each extend in a second direction, the second direction may intersect the first direction, and the second source/drain area may be between the first gate electrode and the second gate electrode. In a plan view, the first auxiliary electrode may not overlap the first source/drain area in the second direction and the first auxiliary electrode may overlap the second source/drain area in the second direction.

In some embodiments, forming impurities in the substrate may further include forming an impurity area in the substrate, wherein the impurity area surrounds the element isolation film. The impurity area may contain an impurity having a second conductivity type, and the second conductivity type may be different from the first conductivity type.

In some embodiments, in the plan view, the first auxiliary electrode may be between the second source/drain area and the impurity area.

In some embodiments, the first conductivity type may an n-type, and the second conductivity type may be a p-type.

In some embodiments, the first gate electrode and the first auxiliary electrode may not overlap each other in the first direction.

The specific details of other embodiments are included in the detailed description and drawings.

At least some of the above and other features of the invention are set out in the claims.

### BRIEF DESCRIPTION OF DRAWINGS

The above and other aspects and features of the present disclosure will become more apparent by describing in detail embodiments thereof with reference to the attached drawings, in which:
FIG. 1 is a layout diagram illustrating a semiconductor device according to some embodiments of the present disclosure.
FIG. 2 is a schematic cross-sectional view taken along a line A - A of FIG. 1.
FIG. 3 is a schematic cross-sectional view taken along a line B - B of FIG. 1.
FIG. 4 is a schematic cross-sectional view taken along a line C - C of FIG. 1.
FIG. 5 is a schematic cross-sectional view taken along a line D - D of FIG. 1.
FIG. 6 is an enlarged view illustrating an area R1 of FIG. 1.
FIG. 7 is a layout diagram illustrating a semiconductor device according to some embodiments of the present disclosure.
FIG. 8 is a schematic cross-sectional view cut along a line A - A of FIG. 7.
FIG. 9 is a layout diagram illustrating a semiconductor device according to some embodiments of the present disclosure.
FIG. 10 is a schematic cross-sectional view taken along a line A - A of FIG. 9.
FIG. 11 is a layout diagram illustrating a semiconductor device according to some embodiments of the present disclosure.
FIG. 12 is a schematic cross-sectional view taken along a line A-A of FIG. 11.
FIG. 13 is a layout diagram illustrating a semiconductor device according to some embodiments of the present disclosure.
FIG. 14 is a layout diagram illustrating a semiconductor device according to some embodiments of the present disclosure.
FIG. 15 is a layout diagram illustrating a semiconductor device according to some embodiments of the present disclosure.
FIG. 16 is an enlarged diagram illustrating an area R2 of FIG. 15.
FIG. 17 is a layout diagram illustrating a semiconductor device according to some embodiments of the present disclosure.
FIG. 18 is a schematic cross-sectional view taken along a line A - A of FIG. 17.
FIG. 19 is a schematic cross-sectional view taken along a line C - C of FIG. 17.
FIG. 20 is a schematic block diagram illustrating a nonvolatile memory device according to some embodiments of the present disclosure.
FIG. 21 is a schematic cross-sectional diagram illustrating a nonvolatile memory device according to some embodiments of the present disclosure.
FIGS. 22 and 23 are various enlarged views illustrating an area R3 of FIG. 21.
FIG. 24 is a schematic cross-sectional view illustrating a semiconductor device according to some embodiments of the present disclosure.
FIG. 25 is an enlarged view for illustrating an area R4 of FIG. 24.
FIGS. 26 to 33 are diagrams of intermediate structures corresponding to intermediate steps of a method for manufacturing a semiconductor device according to some embodiments of the present disclosure.
FIG. 34 is an example block diagram illustrating an electronic system according to some embodiments of the present disclosure.
FIG. 35 is an example perspective view illustrating an electronic system according to some embodiments of the present disclosure.
FIG. 36 and FIG. 37 are schematic cross-sectional views taken along a line I-I' of FIG. 35 according to some embodiments of the present disclosure.

### DETAILED DESCRIPTIONS

Hereinafter, embodiments of the present disclosure are described in detail with reference to the attached drawings. The same reference numerals are used for the same components in the drawings, and duplicate descriptions thereof are omitted.

Expressions such as "at least one of," when preceding a list of elements, modify the entire list of elements and do not modify the individual elements of the list. For example, "at least one of A, B, and C," and similar language (e.g., "at least one selected from the group consisting of A, B, and C" and "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Although terms such as first, second, upper, and lower are used herein to describe various elements or components, these element or components are not limited by the terms. Rather, the terms are merely used herein to distinguish one element or component from another element or component. Therefore, a first element or component as mentioned below may also be a second element or component. Further, a lower element or component as mentioned below may also be an upper element or component.

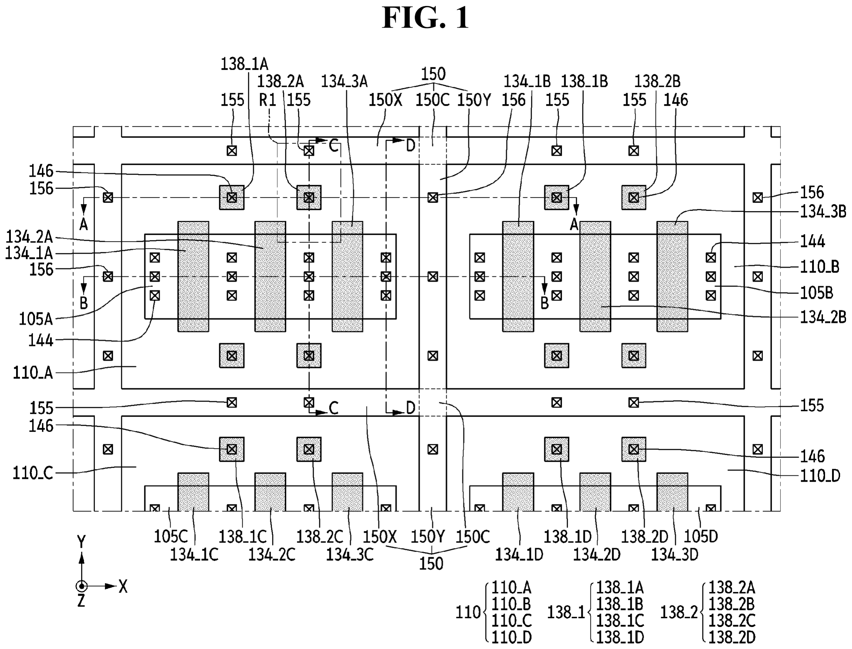

Hereinafter, with reference to FIGS. 1 to 19, a semiconductor device according to some embodiments is described.

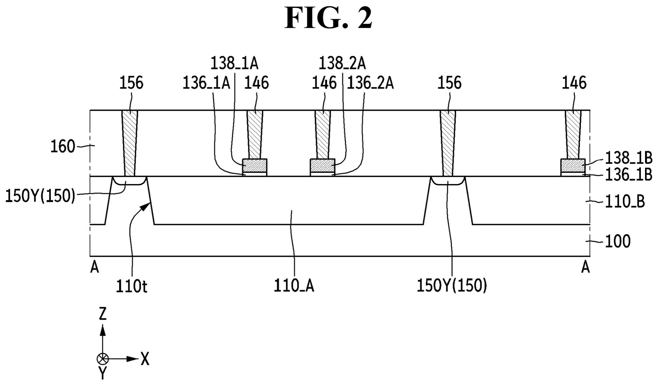

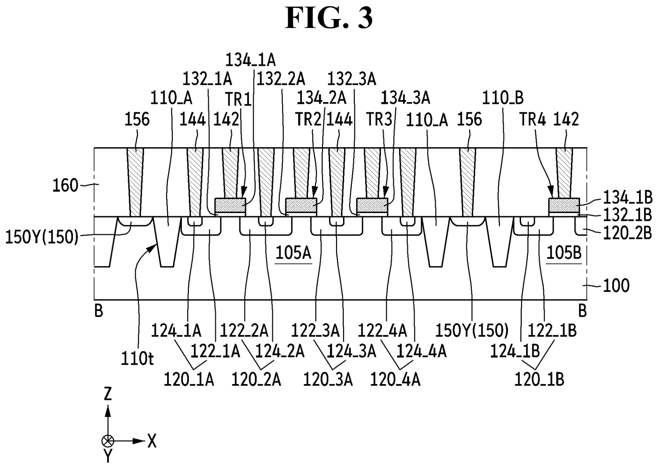

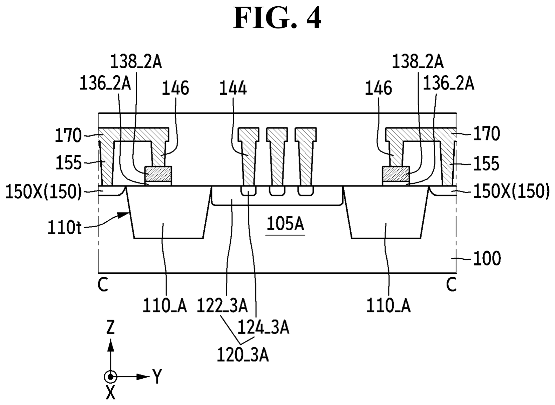

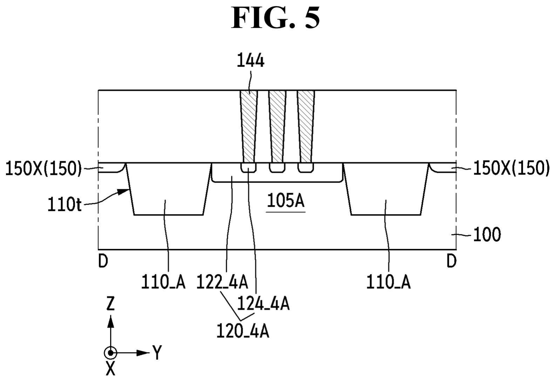

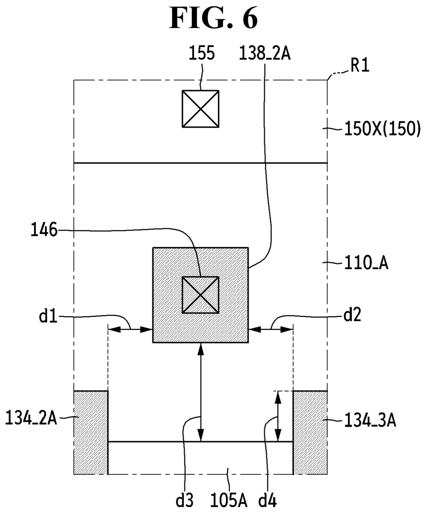

FIG. 1 is a layout diagram for illustrating a semiconductor device according to some embodiments of the present disclosure. FIG. 2 is a schematic cross-sectional view taken along a line A - A of FIG. 1. FIG. 3 is a schematic cross-sectional view taken along a line B - B of FIG. 1. FIG. 4 is a schematic cross-sectional view taken along a line C - C of FIG. 1. FIG. 5 is a schematic cross-sectional view taken along a line D - D of FIG. 1. FIG. 6 is an enlarged view for illustrating an area R1 of FIG. 1.

Referring to FIGS. 1 to 6, a semiconductor device according to some embodiments of the present disclosure may include a first substrate 100, an element isolation film 110, first to fourth circuit elements TR1, TR2, TR3 and TR4, first auxiliary electrodes 138_1A, 138_1B, 138_1C and 138_1D (hereinafter, 138_1), second auxiliary electrodes 138_2A, 138_2B, 138_2C, and 138_2D (hereinafter, 138_2), an impurity area 150, a gate contact 142, a source/drain contact 144, an auxiliary electrode contact 146, a first impurity area contact 155, a second impurity area contact 156, an interlayer insulating film 160, and a connection pattern 170. For the convenience of illustration, the gate contact 142 is omitted in FIG. 1.

The first substrate 100 may include a base substrate and an epi layer grown on the base substrate. However, embodiments of the present disclosure are not limited thereto. For example, the first substrate 100 may include only the base substrate without the epi layer. The first substrate 100 may be a silicon substrate, a gallium arsenide substrate, a silicon germanium substrate, a ceramic substrate, a quartz substrate, a glass substrate for a display, or the like, or may be a SOI (Semiconductor On Insulator) substrate. Hereinafter, an example in which the first substrate 100 is embodied as a silicon substrate is described.

In some embodiments of the present disclosure, the first substrate 100 may be doped with a first conductivity type impurity. For example, when each of the first to fourth circuit elements TR1, TR2, TR3 and TR4 described below is an n-type transistor, the first substrate 100 may be doped with a p-type impurity. Although not shown, the first substrate 100 may include a well doped with the first conductive type impurity.

The element isolation film 110 may include first to fourth element isolation films 110_A, 110_B, 110_C, and 110_D. The element isolation film 110 may define a plurality of active areas 105A, 105B, 105C and 105D within the first substrate 100. For example, the first to fourth element isolation films 110_A, 110_B, 110_C, and110_D may respectively define the plurality of active areas 105A, 105B, 105C and 105D within the first substrate 100. Hereinafter, the element isolation film 110 is depicted or described as including only the first to fourth element isolation films 110_A, 110_B, 110_C and 110_D. However, the technical idea of the present disclosure is not limited thereto.

An element isolation trench 110t may be formed within the first substrate 100 to define each of the plurality of active areas 105A, 105B, 105C and 105D. The first to fourth element isolation films 110_A, 110_B, 110_C and 110_D may fill the corresponding element isolation trenches 110t, respectively. The first to fourth element isolation films 110_A, 110_B, 110_C and 110_D may surround the active areas 105A, 105B, 105C and 105D, respectively. In some embodiments of the present disclosure, a depth at which the element isolation trench 110t is formed may be in a range of about 3000 Å to about 5000 Å. However, this is only an example.

The first to fourth element isolation films 110_A, 110_B, 110_C and 110_D may be spaced apart from each other. For example, the first element isolation film 110_A and the second element isolation film 110_B may be spaced apart from each other in a first direction X. Furthermore, for example, the first element isolation film 110_A and the third element isolation film 110_C may be spaced apart from each other in a second direction Y intersecting the first direction X, for example wherein the second direction Y is different, for example orthogonal, to the first direction X. In a plan view of FIG. 1, the element isolation films 110 may be arranged in a matrix form.

In FIGS. 2 to 5, a side surface of the element isolation film 110 is depicted as having an inclination. However, this is only a feature of a process of forming the element isolation film 110. However, the technical idea of the present disclosure is not limited thereto.

In some embodiments of the present disclosure, the element isolation film 110 may be formed as a single film as illustrated in FIGS. 2 to 5. However, the technical idea of the present disclosure is not limited thereto. For example, the element isolation film 110 may be formed as a stack of multi films. Specifically, the element isolation film 110 may include an insulating liner, an etch-stop liner, and a gap-fill insulating film that are sequentially stacked within the element isolation trench 110t. The insulating liner may extend conformally along a profile of a side surface and a lower surface of the element isolation trench 110t. The etch-stop liner may extend conformally along a profile of the insulating liner. The gap-fill insulating film may fill an area of the element isolation trench 110t remaining after the insulating liner and the etch-stop liner have been formed therein.

The element isolation film 110 may include, for example, at least one of silicon oxide, silicon nitride, silicon oxynitride, and a combination thereof. However, embodiments of the present disclosure are not limited thereto.

The first to fourth active areas 105A, 105B, 105C and 105D may be surrounded with the first to fourth element isolation films 110_A, 110_B, 110_C and 110_D, respectively. The first to fourth active areas 105A, 105B, 105C and 105D may be isolated from each other via the first to fourth element isolation films 110_A, 110_B, 110_C and 110_D, respectively. For example, the plurality of active areas 105A, 105B, 105C and 105D may include the first active area 105A and the second active area 105B arranged along the first direction X. A portion of the first element isolation film 110_A and a portion of the second element isolation film 110_B disposed between the first active area 105A and the second active area 105B may extend in the second direction Y to isolate the first active area 105A and the second active area 105B from each other.

Furthermore, for example, the plurality of active areas 105A, 105B, 105C and 105D may include the first active area 105A and the third active area 105C arranged along the second direction Y, and the second active area 105B and the fourth active area 105D arranged along the second direction Y. A portion of the first element isolation film 110_A and a portion of the third element isolation film 110_C disposed between the first active area 105A and the third active area 105C may extend in the first direction X to isolate the first active area 105A and the third active area 105C from each other. A portion of the second element isolation film 110_B and a portion of the fourth element isolation film 110_D disposed between the second active area 105B and the fourth active area 105D may extend in the first direction X to isolate the second active area 105B and the fourth active area 105D from each other.

The impurity area 150 may be disposed in the first substrate 100. The impurity area 150 may be disposed to surround the element isolation film 110 and within the first substrate 100. The impurity area 150 may be disposed to surround each of the plurality of active areas 105A, 105B, 105C and 105D and within the first substrate 100.

In some embodiments of the present disclosure, the impurity area 150 may include a first impurity area 150X extending in the first direction X, a second impurity area 150Y extending in the second direction Y, and a third impurity area 150C as an area where the first impurity area 150X and the second impurity area 150Y intersect with each other.

The impurity area 150 may be disposed between adjacent element isolation films 110. The impurity area 150 may be disposed between adjacent element isolation trenches 110t. For example, the first impurity area 150X may be disposed between the first element isolation film 110_A and the third element isolation film 110_C and may extend in the first direction X. Furthermore, for example, the second impurity area 150Y may be disposed between the first element isolation film 110_A and the second element isolation film 110_B and may extend in the second direction Y.

The impurity area 150 may be doped with the first conductivity type impurity. For example, when each of the first to fourth circuit elements TR1, TR2, TR3 and TR4 as described below is an n-type transistor, the impurity area 150 may contain a p-type impurity. In some embodiments of the present disclosure, a doping concentration of the impurity area 150 may be higher than a doping concentration of the first substrate 100.

The second impurity area contact 156 may extend in the third direction Z so as to contact the impurity area 150. The second impurity area contact 156 may apply a ground voltage to the impurity area 150. In one example, the third direction Z may mean a direction substantially perpendicular to the first direction X and the second direction Y, and the first direction X and the second direction Y may be substantially orthogonal to each other.

The second impurity area contact 156 may include, but is not limited to, a metal such as aluminum (Al), copper (Cu), or tungsten (W). Furthermore, the number and arrangement of the second impurity area contacts 156 illustrated in FIGS. 1 to 3 are merely examples, and the technical idea of the present disclosure is not limited thereto. For example, the second impurity area contact 156 may also be disposed on the first impurity area 150X.

The first to fourth circuit elements TR1, TR2, TR3 and TR4 may be disposed on the active areas 105A, 105B, 105C and 105D. For example, the first circuit element TR1, the second circuit element TR2, and the third circuit element TR3 may be disposed on the first active area 105A, and the fourth circuit element TR4 may be disposed on the second active area 105B. However, unlike what is illustrated, not three circuit elements but two or four or more circuit elements may be disposed on each of the active areas 105A, 105B, 105C and 105D. Herein, for convenience of description, the description is based on the arrangement of three circuit elements on each of the active areas 105A, 105B, 105C and 105D.

The first circuit element TR1 may include a first gate dielectric film 132_1A, a first gate electrode 134_1A, a first source/drain area 120_1A, and a second source/drain area 120_2A. The first gate electrode 134_1A may extend in one direction (for example, the second direction Y) while being disposed on the first active area 105A. The first gate dielectric film 132_1A may be interposed between the first substrate 100 and the first gate electrode 134_1A.

The first source/drain area 120_1A may be disposed in the first active area 105A and on one side of the first gate electrode 134_1A. The second source/drain area 120_2A may be disposed in the first active area 105A and on the other side of the first gate electrode 134_1A. For example, the first gate electrode 134_1A may extend in the second direction Y while being disposed on the first active area 105A and between the first source/drain area 120_1A and the second source/drain area 120_2A. Furthermore, for example, the second source/drain area 120_2A may be disposed on the first active area 105A and may be interposed between the first gate electrode 134_1A and the second gate electrode 134_2A.

The first source/drain area 120_1A may be adjacent to the first element isolation film 110_A in the first direction X. The first source/drain area 120_1A may be in contact with the first element isolation film 110_A in the first direction X. For example, in the third direction Z, at least a portion of the first source/drain area 120_1A may overlap the first element isolation film 110_A. For example, in a plan view parallel to an upper surface of the first substrate 100, at least a portion of the first source/drain area 120_1A may be aligned in the third direction Z with at least a portion of the first element isolation film 110_A. For example, in a plan view parallel to an upper surface of the first substrate 100, the first source/drain area 120_1A may extend over a range of positions in the first direction X which may overlap with a range of positions in the first direction X over which the first element isolation film 110_A extends.

In some embodiments of the present disclosure, the first source/drain area 120_1A may be a drain area of the first circuit element TR1, and the second source/drain area 120_2A may be a source area of the first circuit element TR1. For example, when the first circuit element TR1 is an n-type transistor, a relatively higher voltage than a voltage applied to the second source/drain area 120_2A may be applied to the first source/drain area 120_1A. In one example, a voltage of about 5 V may be applied to the first source/drain area 120_1A, and a voltage of 0 V may be applied to the second source/drain area 120_2A. Conversely, when the first circuit element TR1 is a p-type transistor, a relatively lower voltage than a voltage applied to the second source/drain area 120_2A may be applied to the first source/drain area 120_1A.

The second circuit element TR2 may include a second gate dielectric film 132_2A, a second gate electrode 134_2A, a second source/drain area 120_2A, and a third source/drain area 120_3A. The second gate electrode 134_2A may extend in one direction (for example, the second direction Y) while being disposed on the first active area 105A. In one example, the second gate electrode 134_2A may extend parallel to the first gate electrode 134_1A. The second gate dielectric film 132_2A may be interposed between the first substrate 100 and the second gate electrode 134_2A.

The second source/drain area 120_2A may be disposed in the first active area 105A and on one side of the second gate electrode 134_2A. The third source/drain area 120_3A may be disposed in the first active area 105A and on the other side of the second gate electrode 134_2A. The second source/drain area 120_2A may be spaced apart from the first source/drain area 120_1A in the first direction X. The third source/drain area 120_3A may be spaced apart from the second source/drain area 120_2A in the first direction X.

In some embodiments of the present disclosure, the first circuit element TR1 and the second circuit element TR2 may share the second source/drain area 120_2A. For example, the second source/drain area 120_2A may be a source area of the first circuit element TR1 and a source area of the second circuit element TR2.

In some embodiments of the present disclosure, the second source/drain area 120_2A may be a source area of the second circuit element TR2, and the third source/drain area 120_3A may be a drain area of the second circuit element TR2. For example, when the second circuit element TR2 is an n-type transistor, a relatively higher voltage than a voltage applied to the second source/drain area 120_2A may be applied to the third source/drain area 120_3A. In one example, a voltage of about 5 V may be applied to the third source/drain area 120_3A, and a voltage of 0 V may be applied to the second source/drain area 120_2A. Conversely, in the case where the second circuit element TR2 is a p-type transistor, a relatively lower voltage than a voltage applied to the second source/drain area 120_2A may be applied to the third source/drain area 120_3A.

The third circuit element TR3 may include a third gate dielectric film 132_3A, a third gate electrode 134_3A, the third source/drain area 120_3A, and a fourth source/drain area 120_4A. The third gate electrode 134_3A may extend in one direction (for example, in the second direction Y) while being disposed on the first active area 105A. In one example, the third gate electrode 134_3A may extend parallel to the first gate electrode 134_1A and the second gate electrode 134_2A. The third gate dielectric film 132_3A may be interposed between the first substrate 100 and the third gate electrode 134_3A.

The third source/drain area 120_3A may be disposed in the first active area 105A and on one side of the third gate electrode 134_3A. The fourth source/drain area 120_4A may be disposed in the first active area 105A and on the other side of the third gate electrode 134_3A. The fourth source/drain area 120_4A may be spaced apart from the third source/drain area 120_3A in the first direction X. For example, the third gate electrode 134_3A may extend in the second direction Y while being disposed on the first active area 105A and between the third source/drain area 120_3A and the fourth source/drain area 120_4A.

The fourth source/drain area 120_4A may be adjacent to the first element isolation film 110_A in the first direction X. The fourth source/drain area 120_4A may be in contact with the first element isolation film 110_A in the first direction X. For example, in the third direction Z, at least a portion of the fourth source/drain area 120_4A may overlap the first element isolation film 110_A. For example, in a plan view parallel to an upper surface of the first substrate 100, at least a portion of the fourth source/drain area 120_4A may be aligned in the third direction Z with at least a portion of the first element isolation film 110_A. For example, in a plan view parallel to an upper surface of the first substrate 100, the fourth source/drain area 120_4A may extend over a range of positions in the first direction X which may overlap with a range of positions in the first direction X over which the first element isolation film 110_A extends.

In some embodiments of the present disclosure, the second circuit element TR2 and the third circuit element TR3 may share the third source/drain area 120_3A. For example, the third source/drain area 120_3A may be a drain area of the second circuit element TR2 and a drain area of the third circuit element TR3.

In some embodiments of the present disclosure, the third source/drain area 120_3A may be a drain area of the third circuit element TR3, and the fourth source/drain area 120_4A may be a source area of the third circuit element TR3. For example, when the third circuit element TR3 is an n-type transistor, a relatively higher voltage than a voltage applied to the fourth source/drain area 120_4A may be applied to the third source/drain area 120_3A. In one example, a voltage of about 5 V may be applied to the third source/drain area 120_3A, and a voltage of 0 V may be applied to the fourth source/drain area 120_4A. Conversely, when the third circuit element TR3 is a p-type transistor, a relatively lower voltage than a voltage applied to the fourth source/drain area 120_4A may be applied to the third source/drain area 120_3A.

The fourth circuit element TR4 may be disposed on the second active area 105B. The fourth circuit element TR4 may include a first gate dielectric film 132_1B, a first gate electrode 134_1B, a first source/drain area 120_1B, and a second source/drain area 120_2B. The description of the fourth circuit element TR4 is similar to that as set forth above with reference to the first circuit element TR1. Thus, detailed description thereof is omitted.

Each of the first to third gate dielectric films 132_1A, 132_2A, 132_3A, and 132_1B may include, but is not limited to, silicon oxide, silicon oxynitride, silicon nitride, and a high-k material having a dielectric constant higher than that of silicon oxide. The high dielectric constant material may include, but is not limited to, at least one of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, and combinations thereof.

In some embodiments of the present disclosure, each of the first to fourth circuit elements TR1, TR2, TR3 and TR4 may be a high voltage transistor. For example, each of the first to fourth circuit elements TR1, TR2, TR3 and TR4 may include each of the first to third gate dielectric films 132_1A, 132_2A, 132_3A, and 132_1B having a thickness of about 200 Å or greater. However, the present disclosure is not limited thereto.

Each of the first to third gate electrodes 134_1A, 134_2A, 134_3A, and 134_1B may include, but is not limited to, at least one of polycrystalline silicon (poly Si), amorphous silicon (a-Si), titanium (Ti), titanium nitride (TiN), tungsten nitride (WN), titanium aluminum (TiAl), titanium aluminum nitride (TiAlN), tantalum nitride (TaN), titanium carbide (TiC), tantalum carbide (TaC), tantalum carbon nitride (TaCN), tantalum silicon nitride (TaSiN), tantalum (Ta), cobalt (Co), ruthenium (Ru), aluminum (Al), tungsten (W), and combinations thereof.

In some embodiments of the present disclosure, each of the first to fourth circuit elements TR1, TR2, TR3 and TR4 may be a high-voltage transistor. For example, a high voltage of about 5 V to about 100 V may be applied to each of the first to third gate electrodes 134_1A, 134_2A, 134_3A, and 134_1B. However, embodiments of the present disclosure are not limited thereto.

Each of the first to fourth source/drain areas 120_1A, 120_2A, 120_3A, 120_4A, 120_1B, and 120_2B may be doped with a second conductivity type impurity different from the first conductivity type impurity. For example, each of the first to fourth source/drain areas 120_1A, 120_2A, 120_3A, 120_4A, 120_1B, and 120_2B may contain an n-type impurity.

In some embodiments of the present disclosure, each of the first to fourth source/drain areas 120_1A, 120_2A, 120_3A, 120_4A, 120_1B, and 120_2B may include a low-concentration impurity area 122_1A, 122_2A, 122_3A, and 122_4A and a high-concentration impurity area 124_1A, 124_2A, 124_3A, and 124_4A. The high-concentration impurity areas 124_1A, 124_2A, 124_3A, and 124_4A may be formed within the low-concentration impurity area 122_1A, 122_2A, 122_3A, and 122_4A, respectively. The low-concentration impurity areas 122_1A, 122_2A, 122_3A, and 122_4A may surround the high-concentration impurity areas 124_1A, 124_2A, 124_3A, and 124_4A, respectively.

Each of the low-concentration impurity areas 122_1A, 122_2A, 122_3A, and 122_4A and the high-concentration impurity areas 124_1A, 124_2A, 124_3A, and 124_4A may be doped with the second conductive type impurity. In this regard, the doping concentration of each of the high-concentration impurity areas 124_1A, 124_2A, 124_3A, and 124_4A may be higher than the doping concentration of each of the low-concentration impurity areas 122_1A, 122_2A, 122_3A, and 122_4A.

Although not shown, each of the first to fourth circuit elements TR1, TR2, TR3 and TR4 may further include a gate spacer covering a side surface of each of the first to third gate electrodes 134_1A, 134_2A, 134_3A, and 134_1B. Furthermore, although not shown, each of the first to fourth circuit elements TR1, TR2, TR3 and TR4 may further include a gate capping pattern covering an upper surface of each of the first to third gate electrodes 134_1A, 134_2A, 134_3A, and 134_1B. Furthermore, although not shown, each of the first to fourth circuit elements TR1, TR2, TR3 and TR4 may further include an etch-stop film covering each of the first to fourth source/drain areas 120_1A, 120_2A, 120_3A, 120_4A, 120_1B, and 120_2B, the gate spacer, and the gate capping pattern.

The description of the second and third gate electrodes 134_2B and 134_3B disposed on the second active area 105B is similar to the description of the second and third gate electrodes 134_2A and 134_3A disposed on the first active area 105A, and therefore is omitted. The description of the first to third gate electrodes 134_1C, 134_2C, and 134_3C disposed on the third active area 105C is similar to the description of the first to third gate electrodes 134_1A, 134_2A, and 134_3A disposed on the first active area 105A, and therefore is omitted. Furthermore, the description of the first to third gate electrodes 134_1D, 134_2D, and 134_3D disposed on the fourth active area 105D is similar to the description of the first to third gate electrodes 134_1A, 134_2A, and 134_3A disposed on the first active area 105A, and therefore is omitted.

The first and second auxiliary electrodes 138_1 and 138_2 may be disposed on the element isolation film 110. The first and second auxiliary electrodes 138_1 and 138_2 may be disposed on an upper surface of the element isolation film 110. In some embodiments of the present disclosure, the first and second auxiliary electrodes 138_1 and 138_2 may be disposed on a portion of the element isolation film 110 disposed between each of the active areas 105A, 105B, 105C and 105D and the first impurity area 150X. The first and second auxiliary electrodes 138_1 and 138_2 may not be disposed on a portion of the element isolation film 110 disposed between each of the active areas 105A, 105B, 105C and 105D and the second impurity area 150Y.

A ground voltage may be applied to the first and second auxiliary electrodes 138_1 and 138_2. In some embodiments of the present disclosure, the first and second auxiliary electrodes 138_1 and 138_2 may be connected to the impurity area 150 via the auxiliary electrode contact 146, the connection pattern 170, and the first impurity area contact 155 as described below, so that the ground voltage may be applied to the first and second auxiliary electrodes 138_1 and 138_2.

In some embodiments of the present disclosure, the first and second auxiliary electrodes 138_1 and 138_2 and the first to third gate electrodes 134_1A to 134_1D, 134_2A to 134_2D, and 134_3A to 134_3D may be formed at the same level. Furthermore, the first and second auxiliary electrodes 138_1 and 138_2 may be formed at the same level. In this regard, "being formed at the same level" may mean being formed at the same step in a manufacturing process of the semiconductor device.

In some embodiments of the present disclosure, each of the first and second auxiliary electrodes 138_1 and 138_2 may have the same material composition as that of each of the first to third gate electrodes 134_1A to 134_1D, 134_2A to 134_2D, and 134_3A to 134_3D. For example, each of the first and second auxiliary electrodes 138_1 and 138_2 may include, but is not limited to, at least one of polycrystalline silicon (poly Si), amorphous silicon (a-Si), titanium (Ti), titanium nitride (TiN), tungsten nitride (WN), titanium aluminum (TiAl), titanium aluminum nitride (TiAlN), tantalum nitride (TaN), titanium carbide (TiC), tantalum carbide (TaC), tantalum carbon nitride (TaCN), tantalum silicon nitride (TaSiN), tantalum (Ta), cobalt (Co), ruthenium (Ru), aluminum (Al), tungsten (W), and combinations thereof.

Each of the first and second auxiliary electrodes 138_1 and 138_2 is illustrated as having a rectangle or square shape in a plan view. However, embodiments of the present disclosure are not limited thereto. The first and second auxiliary electrodes 138_1 and 138_2 may be spaced apart from each other in the first direction X, as will be described later.

In a plan view parallel to an upper surface of the first substrate 100, the first auxiliary electrode 138_1A disposed on the first element isolation film 110_A may overlap with the second source/drain area 120_2A in the second direction Y. For example, in a plan view parallel to an upper surface of the first substrate 100, at least a portion of the first auxiliary electrode 138_1A disposed on the first element isolation film 110_A may be aligned in the second direction Y with at least a portion of the second source/drain area 120_2A. For example, in a plan view parallel to an upper surface of the first substrate 100, the first auxiliary electrode 138_1A disposed on the first element isolation film 110_A may extend over a range of positions in the first direction X which overlaps with a range of positions in the first direction X over which the second source/drain area 120_2A extends. In the plan view, the first auxiliary electrode 138_1A disposed on the first element isolation film 110_A may not overlap with the first source/drain area 120_1A in the second direction Y. For example, in a plan view parallel to an upper surface of the first substrate 100, there may be no alignment in the second direction Y between any portion of the first auxiliary electrode 138_1A disposed on the first element isolation film 110_A and any portion of the first source/drain area 120_1A. For example, in a plan view parallel to an upper surface of the first substrate 100, there may be no overlap between a range of positions in the first direction X over which the first auxiliary electrode 138_1A disposed on the first element isolation film 110_A extends and a range of positions in the first direction X over which the first source/drain area 120_1A extends. In the plan view, the first auxiliary electrode 138_1A disposed on the first element isolation film 110_A may not overlap with the first source/drain area 120_1A in the first direction X. For example, in a plan view parallel to an upper surface of the first substrate 100, there may be no alignment in the first direction X between any portion of the first auxiliary electrode 138_1A disposed on the first element isolation film 110_A and any portion of the first source/drain area 120_1A. For example, in a plan view parallel to an upper surface of the first substrate 100, there may be no overlap between a range of positions in the second direction Y over which the first auxiliary electrode 138_1A disposed on the first element isolation film 110_A extends and a range of positions in the second direction Y over which the first source/drain area 120_1A extends. In the plan view, the first auxiliary electrode 138_1A disposed on the first element isolation film 110_A may be interposed between the first impurity area 150X and the second source/drain area 120_2A. Herein, the plan view parallel to the upper surface of the first substrate 100 may mean a viewpoint looking at a plane substantially perpendicular to the third direction Z.

In other words, the first auxiliary electrode 138_1A disposed on the first element isolation film 110_A may not be disposed on a first portion of the first element isolation film 110_A disposed between the first source/drain area 120_1A and the first impurity area 150X in the plan view. Furthermore, the first auxiliary electrode 138_1A disposed on the first element isolation film 110_A may not be disposed on a second portion of the first element isolation film 110_A disposed between the first portion of the first element isolation film 110_A and the second impurity area 150Y in the plan view. Furthermore, the first auxiliary electrode 138_1A may not be disposed on a third portion of the first element isolation film 110_A disposed between the first source/drain area 120_1A and the second impurity area 150Y in the plan view.

As the semiconductor device becomes increasingly highly integrated, the influence of leakage current is increasingly increasing. For example, characteristic degradation due to off current in a turned-off state of the semiconductor device may occur. Furthermore, as the semiconductor device becomes increasingly highly integrated, the breakdown voltage may decrease, thereby causing characteristic degradation of the semiconductor device.

A multi-finger transistor as one of semiconductor devices may have an increased electron concentration in an area between gate electrodes, and may have a relatively low electron concentration in an end area of the multi-finger transistor.

In some embodiments of the present disclosure, the first auxiliary electrode 138_1A to which the ground voltage is applied may be disposed to overlap the second source/drain area 120_2A in the second direction Y in the plan view. For example, in a plan view parallel to an upper surface of the first substrate 100, at least a portion of the first auxiliary electrode 138_1A disposed on the first element isolation film 110_A may be aligned in the second direction Y with at least a portion of the second source/drain area 120_2A. For example, in a plan view parallel to an upper surface of the first substrate 100, the first auxiliary electrode 138_1A disposed on the first element isolation film 110_A may extend over a range of positions in the first direction X which overlaps with a range of positions in the first direction X over which the second source/drain area 120_2A extends. Thus, when the first auxiliary electrode 138_1A to which the ground voltage is applied is disposed adjacent to the second source/drain area 120_2A, the electron concentration of the second source/drain area 120_2A may be appropriately lowered such that decrease in the off-current and increase in the breakdown voltage may limit and/or prevent the characteristic degradation. Furthermore, since the first to third portions of the element isolation film 110_A correspond to the end areas of the multi-finger transistor where the electron concentration is already relatively low, disposing the first auxiliary electrode 138_1A on those portions could further reduce the electron concentration and cause characteristic degradation. Accordingly, the first auxiliary electrode 138_1A is not disposed on the first to third portions of the element isolation film 110_A, to prevent such excessive reduction and maintain device reliability. Thus, the semiconductor device with improved reliability and/or performance may be provided.

Since the description of each of the first auxiliary electrodes 138_1B, 138_1C and 138_1D respectively disposed on the second to fourth element isolation films 110_B, 110_C and 110_D is similar to the description of the first auxiliary electrode 138_1A disposed on the first element isolation film 110_A, a detailed description thereof is omitted.

In the plan view, the second auxiliary electrode 138_2A disposed on the first element isolation film 110_A may overlap with the third source/drain area 120_3A in the second direction Y. For example, in a plan view parallel to an upper surface of the first substrate 100, at least a portion of the second auxiliary electrode 138_2A disposed on the first element isolation film 110_A may be aligned in the second direction Y with at least a portion of the third source/drain area 120_3A. For example, in a plan view parallel to an upper surface of the first substrate 100, the second auxiliary electrode 138_2A disposed on the first element isolation film 110_A may extend over a range of positions in the first direction X which overlaps with a range of positions in the first direction X over which the third source/drain area 120_3A extends. In the plan view, the second auxiliary electrode 138_2A disposed on the first element isolation film 110_A may not overlap with the fourth source/drain area 120_4A in the second direction Y. For example, in a plan view parallel to an upper surface of the first substrate 100, there may be no alignment in the second direction Y between any portion of the second auxiliary electrode 138_2A disposed on the first element isolation film 110_A and any portion of the fourth source/drain area 120_4A. For example, in a plan view parallel to an upper surface of the first substrate 100, there may be no overlap between a range of positions in the first direction X over which the second auxiliary electrode 138_2A disposed on the first element isolation film 110_A extends and a range of positions in the first direction X over which the fourth source/drain area 120_4A extends. In the plan view, the second auxiliary electrode 138_2A disposed on the first element isolation film 110_A may be interposed between the first impurity area 150X and the third source/drain area 120_3A. The second auxiliary electrode 138_2A disposed on the first element isolation film 110_A may be spaced apart from the first auxiliary electrode 138_1A disposed on the first element isolation film 110_A in the first direction X.

In other words, the second auxiliary electrode 138_2A disposed on the first element isolation film 110_A may not be disposed on a fourth portion of the first element isolation film 110_A disposed between the fourth source/drain area 120_4A and the first impurity area 150X in the plan view. Furthermore, the second auxiliary electrode 138_2A disposed on the first element isolation film 110_A may not be disposed on a fifth portion of the first element isolation film 110_A disposed between the fourth portion of the first element isolation film 110_A and the second impurity area 150Y in the plan view. Furthermore, the second auxiliary electrode 138_2A disposed on the first element isolation film 110_A may not be disposed on a sixth portion of the first element isolation film 110_A disposed between the fourth source/drain area 120_4A and the second impurity area 150Y.

In some embodiments of the present disclosure, the second auxiliary electrode 138_2A to which the ground voltage is applied may be disposed to overlap the third source/drain area 120_3A in the second direction Y in the plan view. For example, in a plan view parallel to an upper surface of the first substrate 100, at least a portion of the second auxiliary electrode 138_2A disposed on the first element isolation film 110_A may be aligned in the second direction Y with at least a portion of the third source/drain area 120_3A. For example, in a plan view parallel to an upper surface of the first substrate 100, the second auxiliary electrode 138_2A disposed on the first element isolation film 110_A may extend over a range of positions in the first direction X which overlaps with a range of positions in the first direction X over which the third source/drain area 120_3A extends. Thus, when the second auxiliary electrode 138_2A to which the ground voltage is applied is disposed adjacent to the third source/drain area 120_3A, the electron concentration of the third source/drain area 120_3A may be appropriately lowered such that the decrease in the off-current and the increase in the breakdown voltage may limit and/or prevent the characteristic deterioration. Furthermore, since the fourth to sixth portions of the element isolation film 110_A correspond to end areas of the multi-finger transistor having a relatively low electron concentration, forming the second auxiliary electrode 138_2A on those portions may further decrease the electron concentration and deteriorate device characteristics. Therefore, the second auxiliary electrode 138_2A is not disposed on the fourth to sixth portions to avoid such excessive depletion and improve device stability. Thus, the semiconductor device with improved reliability and performance may be provided.

The description of each of the second auxiliary electrodes 138_2B, 138_2C, and 138_2D respectively disposed on the second to fourth element isolation films 110_B, 110_C and 110_D is similar to the description of the second auxiliary electrode 138_2A disposed on the first element isolation film 110_A. Thus, the detailed description thereof is omitted.

In FIG. 6, in some embodiments of the present disclosure, the second auxiliary electrode 138_2A disposed on the first element isolation film 110_A may not overlap with the second gate electrode 134_2A and the third gate electrode 134_3A in the first direction X. For example, in a plan view parallel to an upper surface of the first substrate 100, there may be no alignment in the first direction X between any portion of the second auxiliary electrode 138_2A disposed on the first element isolation film 110_A and any portion of the second gate electrode 134_2A or any portion of the third gate electrode 134_3A. For example, in a plan view parallel to an upper surface of the first substrate 100, there may be no overlap between a range of positions in the second direction Y over which the second auxiliary electrode 138_2A disposed on the first element isolation film 110_A extends and a range of positions in the second direction Y over which the second gate electrode 134_2A or the third gate electrode 134_3A extends. For example, in the plan view of FIG. 6, the shortest distance d3 from the first active area 105A to the second auxiliary electrode 138_2A in the second direction Y may be greater than a maximum distance d4 from the first active area 105A to the third gate electrode 134_3A in the second direction Y. In some embodiments of the present disclosure, the shortest distance d3 from the first active area 105A to the second auxiliary electrode 138_2A in the second direction Y may be 0.3 µm. However, this is an example.

Furthermore, in some embodiments of the present disclosure, the second auxiliary electrode 138_2A disposed on the first element isolation film 110_A may not overlap with the second gate electrode 134_2A and the third gate electrode 134_3A in the second direction Y. For example, in a plan view parallel to an upper surface of the first substrate 100, there may be no alignment in the second direction Y between any portion of the second auxiliary electrode 138_2A disposed on the first element isolation film 110_A and any portion of the second gate electrode 134_2A or any portion of the third gate electrode 134_3A. For example, in a plan view parallel to an upper surface of the first substrate 100, there may be no overlap between a range of positions in the first direction X over which the second auxiliary electrode 138_2A disposed on the first element isolation film 110_A extends and a range of positions in the first direction X over which the second gate electrode 134_2A or the third gate electrode 134_3A extends. For example, in the plan view of FIG. 6, a distance d1 from the second gate electrode 134_2A to the second auxiliary electrode 138_2A in the first direction X may be 0.2 µm. Furthermore, for example, in the plan view of FIG. 6, a distance d2 from the second auxiliary electrode 138_2A to the third gate electrode 134_3A in the first direction X may be 0.2 µm.

In some embodiments of the present disclosure, the first auxiliary electrode 138_1A disposed on the first element isolation film 110_A may not overlap with the first gate electrode 134_1A and the second gate electrode 134_2A in the first direction X and the second direction Y. Since the description thereof is similar to the description of the second auxiliary electrode 138_2A, the detailed description thereof is omitted. For example, the first auxiliary electrode 138_1A and the second auxiliary electrode 13 8_2A disposed on the first element isolation film 110_A may be spaced apart from each other in the first direction X.

The first and second auxiliary dielectric films 136_1A, 136_2A, and 136_1B may be interposed between the first and second auxiliary electrodes 138_1A, 138_2A, and 138_1B and the element isolation film 110. The first and second auxiliary dielectric films 136_1A, 136_2A, and 136_1B may be formed at the same level as that of each of the first to third gate dielectric films 132_1A, 132_2A, 132_3A, and 132_1B.

For example, each of the first and second auxiliary dielectric films 136_1A, 136_2A, and 136_1B may include, but is not limited to, silicon oxide, silicon oxynitride, silicon nitride, and high-k materials having a dielectric constant higher than that of silicon oxide. The high dielectric constant material may include, but is not limited to, at least one of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, and combinations thereof.

The interlayer insulating film 160 may be formed on the first substrate 100. The interlayer insulating film 160 may cover the first substrate 100, the element isolation film 110, and the first to fourth circuit elements TR1, TR2, TR3 and TR4.

The interlayer insulating film 160 may include at least one of, for example, silicon oxide, silicon nitride, silicon oxynitride, and a low-k material having a lower dielectric constant than that of silicon oxide. The low-k material may include, but is not limited to, at least one of FOX (Flowable Oxide), TOSZ (Torene SilaZene), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, and combinations thereof.

The gate contact 142 may be in contact with each of the first to third gate electrodes 134_1A to 134_1D, 134_2A to 134_2D, and 134_3A to 134_3D. For example, the gate contact 142 may extend in the third direction Z so as to extend through the interlayer insulating film 160. The gate contact 142 may be electrically connected to each of the first to third gate electrodes 134_1A to 134_1D, 134_2A to 134_2D, and 134_3A to 134_3D and apply a voltage to each of the first to third gate electrodes 134_1A to 134_1D, 134_2A to 134_2D, and 134_3A to 134_3D.

The gate contact 142 may include, but is not limited to, a metal such as aluminum (Al), copper (Cu), or tungsten (W).

The source/drain contact 144 may be in contact with each of the first to fourth source/drain areas 120_1A, 120_2A, 120_3A, 120_4A, 120_1B, and 120_2B. For example, the source/drain contact 144 may extend in the third direction Z so as to extend through the interlayer insulating film 160. The source/drain contact 144 may be electrically connected to each of the first to fourth source/drain areas 120_1A, 120_2A, 120_3A, 120_4A, 120_1B, and 120_2B and may apply the voltage to each of the first to fourth source/drain areas 120_1A, 120_2A, 120_3A, 120_4A, 120_1B, and 120_2B.

The source/drain contact 144 may include, but is not limited to, a metal such as aluminum (Al), copper (Cu), or tungsten (W). In some embodiments, the gate contact 142 and the source/drain contact 144 may be formed at the same level. For example, the gate contact 142 and the source/drain contact 144 may include the same material.

The auxiliary electrode contact 146 may be in contact with each of the first and second auxiliary electrodes 138_1 and 138_2. For example, the auxiliary electrode contact 146 may extend in the third direction Z so as to extend through the interlayer insulating film 160. The auxiliary electrode contact 146 may be electrically connected to each of the first and second auxiliary electrodes 138_1 and 138_2 and may apply the voltage to each of the first and second auxiliary electrodes 138_1 and 138_2.

The auxiliary electrode contact 146 may include, for example, a metal such as aluminum (Al), copper (Cu), or tungsten (W). However, embodiments of the present disclosure are not limited thereto. In some embodiments of the present disclosure, the auxiliary electrode contact 146, the gate contact 142, and the source/drain contact 144 may be formed at the same level.

The first impurity area contact 155 may be in contact with the impurity area 150. The first impurity area contact 155 is illustrated as being in contact with the first impurity area 150X. However, embodiments of the present disclosure are not limited thereto. For example, the first impurity area contact 155 may extend in the third direction Z so as to extend through the interlayer insulating film 160. The first impurity area contact 155 may be electrically connected to the impurity area 150 to apply a voltage to the impurity area 150.

The first impurity area contact 155 may include, but is not limited to, a metal such as aluminum (Al), copper (Cu), or tungsten (W). In some embodiments of the present disclosure, the first impurity area contact 155, the auxiliary electrode contact 146, the gate contact 142, and the source/drain contact 144 may be formed at the same level.

The connection pattern 170 may connect the auxiliary electrode contact 146 and the first impurity area contact 155 to each other in FIG. 4. The connection pattern 170 may connect the first and second auxiliary electrodes 138_1 and 138_2 to the impurity area 150. Through the connection pattern 170, the impurity area 150 to which the ground voltage is applied may be electrically connected to the first and second auxiliary electrodes 138_1 and 138_2, so that the ground voltage may also be applied to the first and second auxiliary electrodes 138_1 and 138_2. Thus, the first and second auxiliary electrodes 138_1 and 138_2 to which the ground voltage is applied may be disposed adjacent to the first to fourth source/drain areas 120_2A, 120_3A, and 120_2B, so that the semiconductor device with improved performance and reliability may be provided.

The connection pattern 170 may include, for example, a metal such as aluminum (Al), copper (Cu), or tungsten (W). However, embodiments of the present disclosure are not limited thereto.

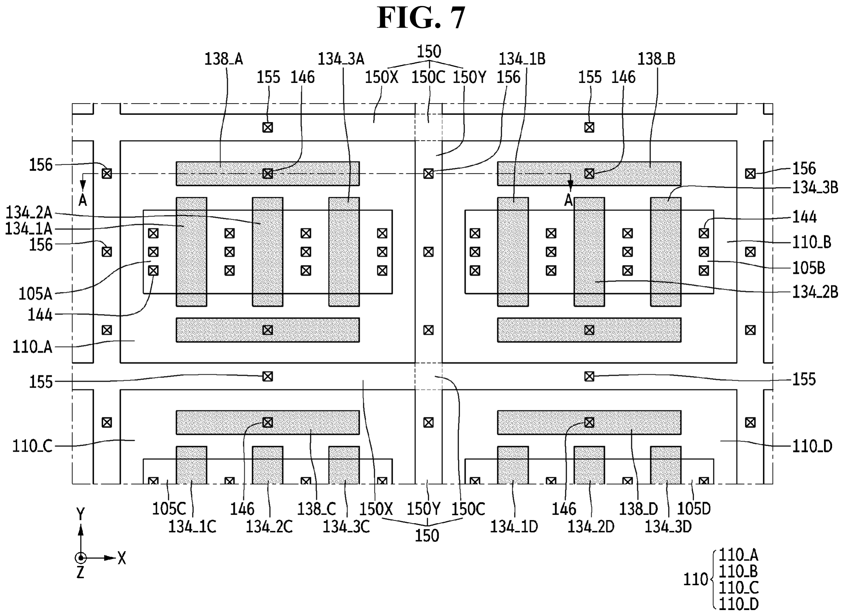

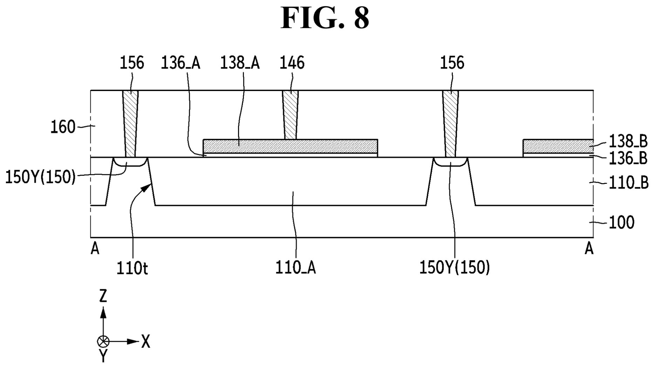

FIG. 7 is a layout diagram for illustrating a semiconductor device according to some embodiments of the present disclosure. FIG. 8 is a schematic cross-sectional view cut along a line A - A of FIG. 7. For the convenience of description, features which duplicate the features which have been described above with reference to FIG. 1 to FIG. 6 are briefly described or descriptions thereof are omitted.

Referring to FIG. 7 and FIG. 8, the auxiliary electrodes 138_A, 138_B, 138_C, and 138_D may overlap with the first to third gate electrodes 134_1A to 134_1D, 134_2A to 134_2D, and 134_3A to 134_3D, the second source/drain area (see 120_2A in FIG. 3), and the third source/drain area (see 120_3A in FIG. 3) in the second direction Y in the plan view. For example, in a plan view parallel to an upper surface of the first substrate 100, at least a portion of the auxiliary electrodes 138_A, 138_B, 138_C, and 138_D may be aligned in the second direction Y with at least a portion of the first to third gate electrodes 134_1A to 134_1D, 134_2A to 134_2D, and 134_3A to 134_3D, with at least a portion of the second source/drain area (see 120_2A in FIG. 3), and with at least a portion of the third source/drain area (see 120_3A in FIG. 3). For example, in a plan view parallel to an upper surface of the first substrate 100, the auxiliary electrodes 138_A, 138_B, 138_C, and 138_D may extend over ranges of positions in the first direction X which overlap with ranges of positions in the first direction X over which the first to third gate electrodes 134_1A to 134_1D, 134_2A to 134_2D, and 134_3A to 134_3D, the second source/drain area (see 120_2A in FIG. 3), and the third source/drain area (see 120_3A in FIG. 3) extend.

In some embodiments of the present disclosure, each of the auxiliary electrodes 138_A, 138_B, 138_C, and 138_D may not be divided into two auxiliary electrodes, but may be embodied as a single structure which extends in an elongate manner in the first direction X, unlike the embodiments of FIG. 1 to FIG. 6 as described above.

In some embodiments of the present disclosure, in the plan view, each of the auxiliary electrodes 138_A, 138_B, 138_C, and 138_D may not overlap with the first source/drain area (see 120_1A of FIG. 3) and the fourth source/drain area (see 120_4A of FIG. 3) in the second direction Y. For example, in a plan view parallel to an upper surface of the first substrate 100, there may be no alignment in the second direction Y between any portion of each of the auxiliary electrodes 138_A, 138_B, 138_C, and 138_D and any portion of the first source/drain area (see 120_1A of FIG. 3) and the fourth source/drain area (see 120_4A of FIG. 3). For example, in a plan view parallel to an upper surface of the first substrate 100, there may be no overlap between a range of positions in the first direction X over which each of the auxiliary electrodes 138_A, 138_B, 138_C, and 138_D extends and a range of positions in the first direction X over which the first source/drain area (see 120_1A of FIG. 3) and the fourth source/drain area (see 120_4A of FIG. 3) extends.

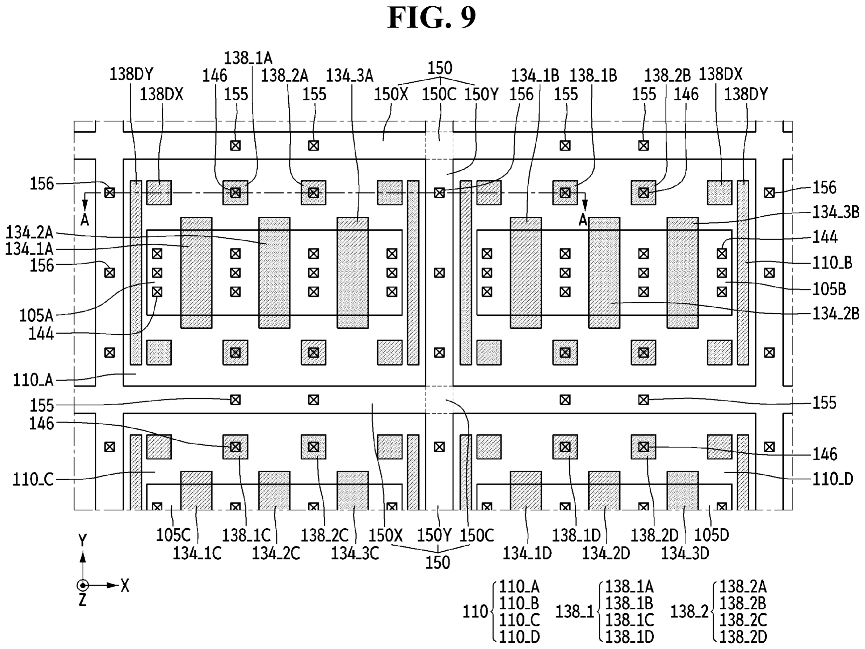

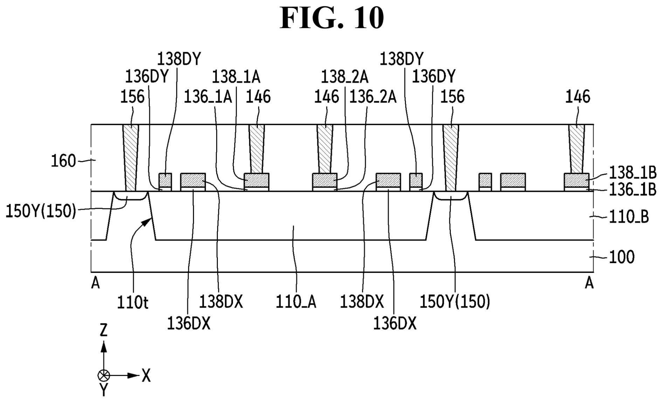

FIG. 9 is a layout diagram for illustrating a semiconductor device according to some embodiments of the present disclosure. FIG. 10 is a schematic cross-sectional view taken along a line A - A of FIG. 9. For the convenience of description, features which duplicate the features which have been described above with reference to FIGS. 1 to 6 will be briefly described or descriptions thereof are omitted.

Referring to FIGS. 9 and 10, the semiconductor device according to some embodiments of the present disclosure may further include a first dummy auxiliary electrode 138DX and a second dummy auxiliary electrode 138DY.

In some embodiments of the present disclosure, the first dummy auxiliary electrode 138DX may overlap the first source/drain area (see 120_1A of FIG. 3) and the fourth source/drain area (see 120_4A of FIG. 3) in the second direction Y in the plan view. For example, in a plan view parallel to an upper surface of the first substrate 100, at least a portion of the first dummy auxiliary electrode 138DX may be aligned in the second direction Y with at least a portion of the first source/drain area (see 120_1A of FIG. 3) and the fourth source/drain area (see 120_4A of FIG. 3). For example, in a plan view parallel to an upper surface of the first substrate 100, the first dummy auxiliary electrode 138DX may extend over a range of positions in the first direction X which overlaps with a range of positions in the first direction X over which the first source/drain area (see 120_1A of FIG. 3) and the fourth source/drain area (see 120_4A of FIG. 3) extend. At least a portion of the second dummy auxiliary electrode 138DY may overlap the first source/drain area 120_1A and the fourth source/drain area 120_4A in the first direction X in the plan view. For example, in a plan view parallel to an upper surface of the first substrate 100, at least a portion of the second dummy auxiliary electrode 138DY may be aligned in the first direction X with at least a portion of the first source/drain area 120_1A and the fourth source/drain area 120_4A. For example, in a plan view parallel to an upper surface of the first substrate 100, the second dummy auxiliary electrode 138DY may extend over a range of positions in the second direction Y which overlaps with a range of positions in the second direction Y over which the first source/drain area 120_1A and the fourth source/drain area 120_4A extend.

In some embodiments of the present disclosure, the first dummy auxiliary electrode 138DX and the second dummy auxiliary electrode 138DY may be formed at the same level as that of each of the first and second auxiliary electrodes 138_1 and 138_2. However, the first dummy auxiliary electrode 138DX and the second dummy auxiliary electrode 138DY may not be in contact with the auxiliary electrode contact 146. That is, no voltage may be applied to the first dummy auxiliary electrode 138DX and the second dummy auxiliary electrode 138DY. Accordingly, even when the first dummy auxiliary electrode 138DX and the second dummy auxiliary electrode 138DY are disposed, the characteristic deterioration may be prevented due to the decrease in the off-current and the increase in the breakdown voltage as in the embodiments as described in FIGS. 1 to 6, so that the semiconductor device with improved performance and reliability may be provided.

The number and arrangement of the first dummy auxiliary electrode 138DX and the second dummy auxiliary electrode 138DY are only examples and are not limited what are illustrated. For example, the first dummy auxiliary electrode 138DX and the second dummy auxiliary electrode 138DY may be connected to each other.

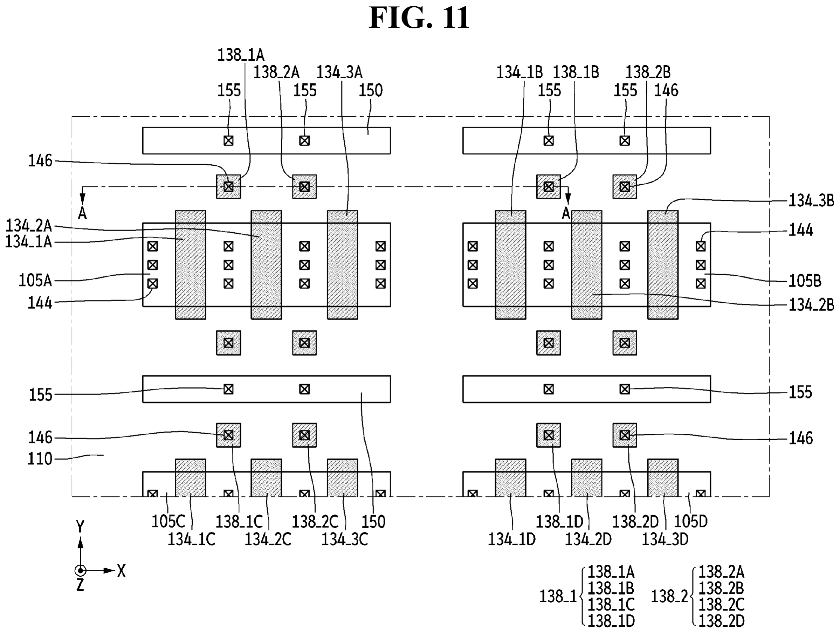

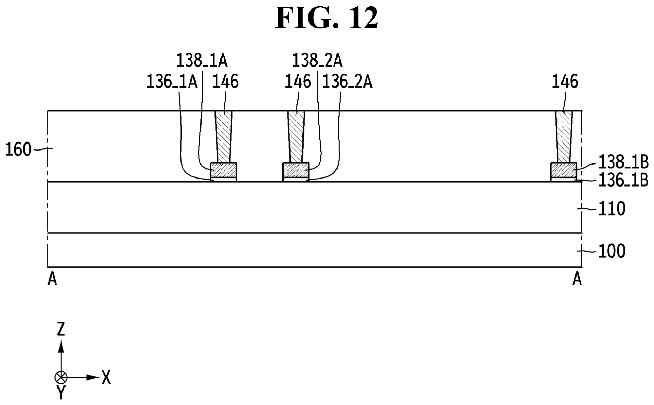

FIG. 11 is a layout diagram for illustrating a semiconductor device according to some embodiments of the present disclosure. FIG. 12 is a schematic cross-sectional view taken along a line A-A of FIG. 11. For convenience of description, features which duplicate the features which have been described above with reference to FIGS. 1 to 6 will be briefly described or descriptions thereof are omitted.

Referring to FIGS. 11 and 12, in some embodiments of the present disclosure, the impurity area 150 may extend in the first direction X.

In some embodiments of the present disclosure, unlike the embodiments as described in FIGS. 1 to 6, the impurity area 150 may not include the second impurity area (see 150Y of FIG. 1) that extends in the second direction Y. That is, the impurity area 150 may isolate the plurality of active areas 105A, 105B, 105C and 105D from each other only in the second direction Y, but may not isolate the plurality of active areas 105A, 105B, 105C and 105D from each other in the first direction X. However, the technical idea of the present disclosure is not limited thereto, and for example, unlike that illustrated in FIG. 11, the impurity area 150 may extend in the second direction Y and may not include the first impurity area (see 150X in FIG. 1) extending in the first direction X.

The first impurity area contact 155 may contact the impurity area 150. Although not illustrated, the second impurity area contact (see 156 in FIG. 1) may contact the impurity area 150.

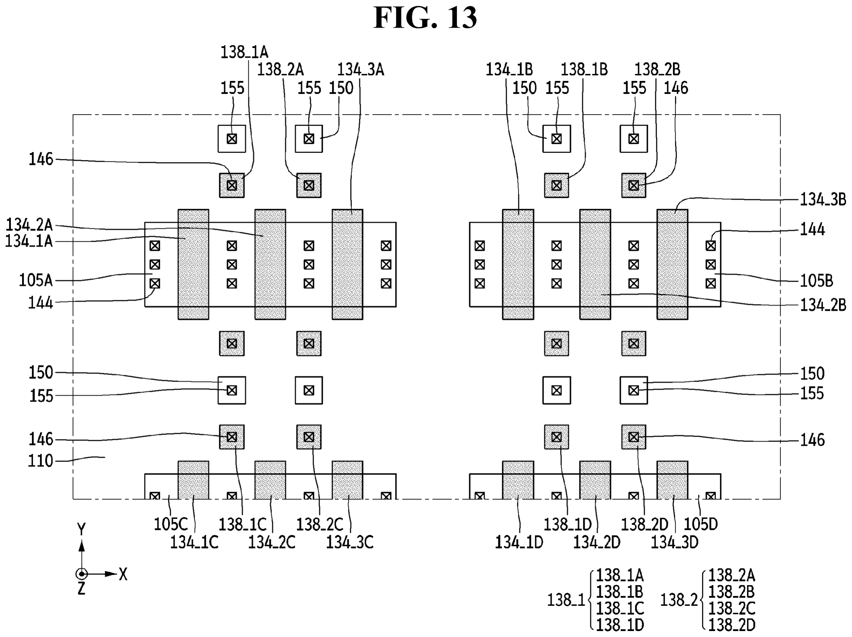

FIG. 13 is a layout diagram for illustrating a semiconductor device according to some embodiments of the present disclosure. For convenience of description, features which duplicate the features which have been described above with reference to FIGS. 1 to 6 are briefly described or descriptions thereof are omitted.

Referring to FIG. 13, in some embodiments of the present disclosure, the impurity area 150 may include a plurality of sub-impurity areas that are spaced apart from each other.

In some embodiments of the present disclosure, the sub-impurity areas may be disposed between the first and second auxiliary electrodes 138_1 and 138_2. For example, the sub-impurity area may be disposed between the first auxiliary electrode 138_1A adjacent to the first active area 105A and the first auxiliary electrode 138_1C adjacent to the third active area 105C. The first impurity area contact 155 may be in contact with the sub-impurity areas.

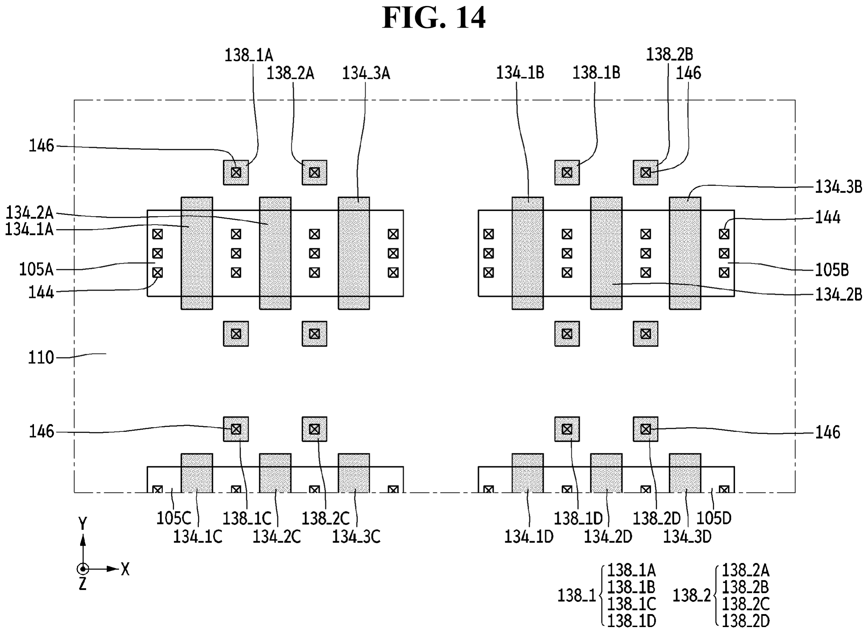

FIG. 14 is a layout diagram for illustrating a semiconductor device according to some embodiments of the present disclosure. For convenience of description, features which duplicate the features which have been described above using FIGS. 1 to 6 are briefly described or descriptions thereof are omitted.

Referring to FIG. 14, the semiconductor device according to some embodiments of the present disclosure may not include an impurity area (see 150 of FIG. 1).

In some embodiments of the present disclosure, the element isolation film 110 may isolate the plurality of active areas 105A, 105B, 105C and 105D from each other in the first direction X and the second direction Y. The first and second auxiliary electrodes 138_1 and 138_2 may be interposed between adjacent ones of the plurality of active areas 105A, 105B, 105C and 105D that are spaced apart from each other in the second direction Y.

In some embodiments of the present disclosure, the auxiliary electrode contact 146 may be contacted to the first and second auxiliary electrodes 138_1 and 138_2. Through the auxiliary electrode contact 146, a ground voltage may be applied to the first and second auxiliary electrodes 138_1 and 138_2.

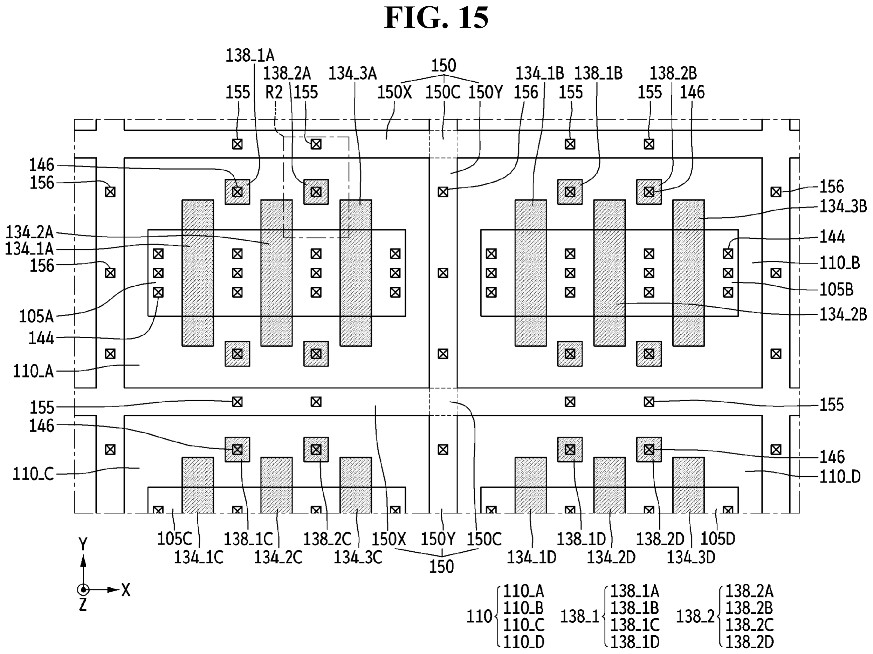

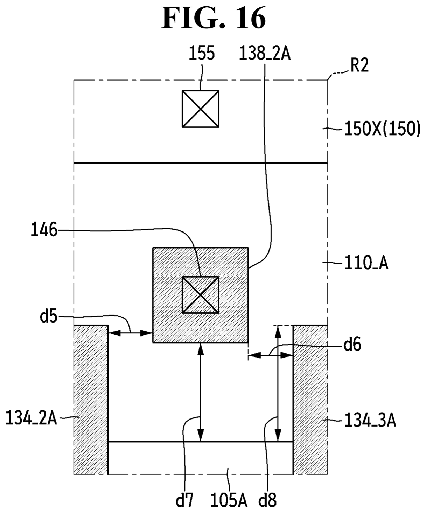

FIG. 15 is a layout diagram for illustrating a semiconductor device according to some embodiments of the present disclosure. FIG. 16 is an enlarged diagram for illustrating an area R2 of FIG. 15. For the convenience of description, features which duplicate the features which have been described above with reference to FIGS. 1 to 6 are briefly described or descriptions thereof are omitted.

Referring to FIG. 15 and FIG. 16, the first and second auxiliary electrodes 138_1 and 138_2 may overlap the first to third gate electrodes 134_1A to 134_1D, 134_2A to 134_2D, and 134_3A to 134_3D in the first direction X. For example, in a plan view parallel to an upper surface of the first substrate 100, at least a portion of the first and second auxiliary electrodes 138_1 and 138_2 may be aligned in the first direction X with at least a portion of the first to third gate electrodes 134_1A to 134_1D, 134_2A to 134_2D, and 134_3A to 134_3D. For example, in a plan view parallel to an upper surface of the first substrate 100, the first and second auxiliary electrodes 138_1 and 138_2 may extend over a range of positions in the second direction Y which overlaps with a range of positions in the second direction Y over which the first to third gate electrodes 134_1A to 134_1D, 134_2A to 134_2D, and 134_3A to 134_3D extend.

In the plan view of FIG. 16, the shortest distance d7 from the first active area 105A to the second auxiliary electrode 138_2A may be smaller than a maximum distance d8 from the first active area 105A to the third source/drain area 134_3A. In this case, the first and second auxiliary electrodes 138_1 and 138_2 to which the ground voltage is applied may achieve the decrease of the off-current and the increase of the breakdown voltage such that the characteristic deterioration is prevented, thereby providing a semiconductor device with improved performance and reliability.

Furthermore, in the plan view of FIG. 16, a distance d5 in the first direction X from the second gate electrode 134_2A to the second auxiliary electrode 138_2A may be 0.2 µm. Furthermore, for example, in the plan view of FIG. 16, a distance d6 in the first direction X from the second auxiliary electrode 138_2A to the third gate electrode 134_3A may be 0.2 µm. However, this is only an example, and the technical idea of the present disclosure is not limited thereto.

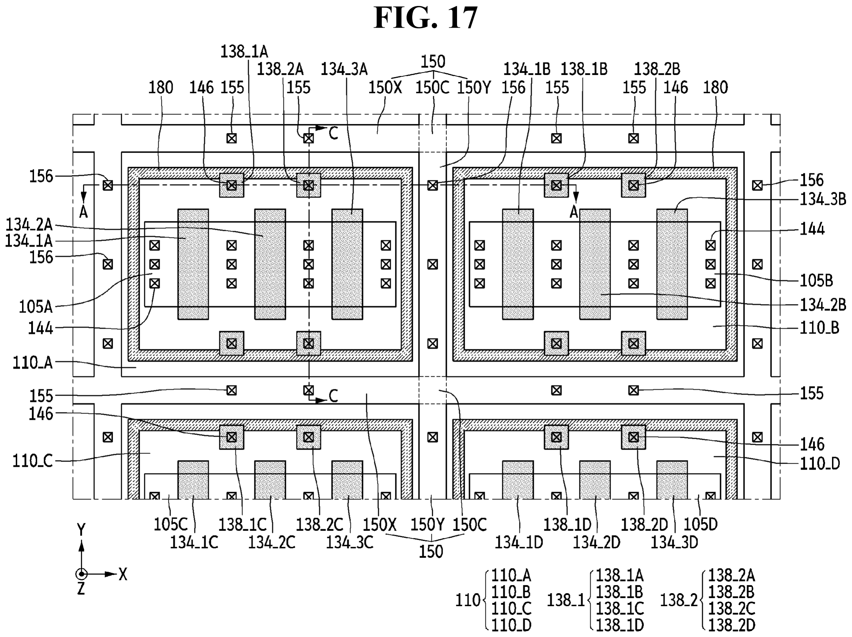

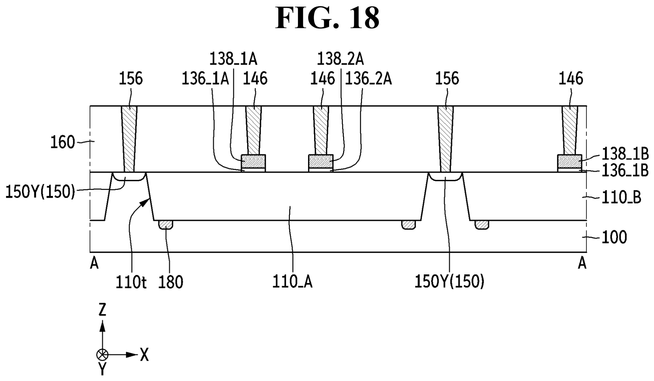

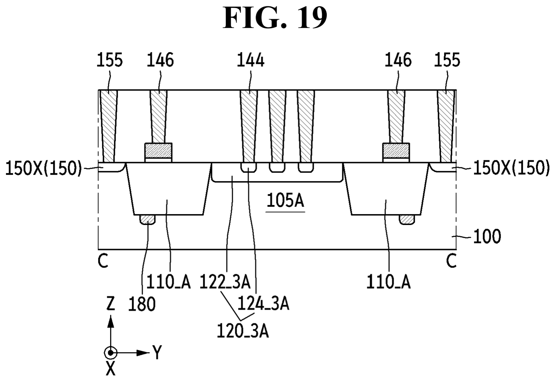

FIG. 17 is a layout diagram for illustrating a semiconductor device according to some embodiments of the present disclosure. FIG. 18 is a schematic cross-sectional view taken along a line A - A of FIG. 17. FIG. 19 is a schematic cross-sectional view taken along a line C - C of FIG. 17. For convenience of description, features which duplicate the features which have been described above with reference to FIGS. 1 to 6 will be briefly described or descriptions thereof are omitted.

Referring to FIGS. 17 and 19, an isolation impurity area 180 may surround the first to fourth active areas 105A, 105B, 105C and 105D. The isolation impurity area 180 may be disposed under each of the element isolation films 110.

For example, a portion of the isolation impurity area 180 may extend in the second direction Y while being disposed between the first active area 105A and the second active area 105B. Furthermore, another portion of the isolation impurity area 180 may extend in the first direction X while being disposed between the first active area 105A and the third active area 105C.

The isolation impurity area 180 may be doped with the first conductivity type impurity. For example, the isolation impurity area 180 may contain a p-type impurity.

The isolation impurity area 180 may overlap at least a portion of each of the first and second auxiliary electrodes 138_1 and 138_2 in the third direction Z. For example, in a plan view parallel to an upper surface of the first substrate 100, at least a portion of the isolation impurity area 180 may be aligned in the third direction Z with at least a portion of each of the first and second auxiliary electrodes 138_1 and 138_2.The isolation impurity area 180 and the first and second auxiliary electrodes 138_1 and 138_2 may be spaced apart from each other while the element isolation film 110 is interposed therebetween.

Since the isolation impurity area 180 is disposed under the element isolation film 110, a problem of lowering the breakdown voltage may occur. However, in the semiconductor device according to some embodiments of the present disclosure, the first and second auxiliary electrodes 138_1 and 138_2 to which the ground voltage is applied are disposed on the element isolation film 110 such that the decrease in the breakdown voltage may be prevented, thereby providing the semiconductor device with improved performance and reliability.

Hereinafter, nonvolatile memory devices according to some embodiments will be described with reference to FIGS. 1 to 25.

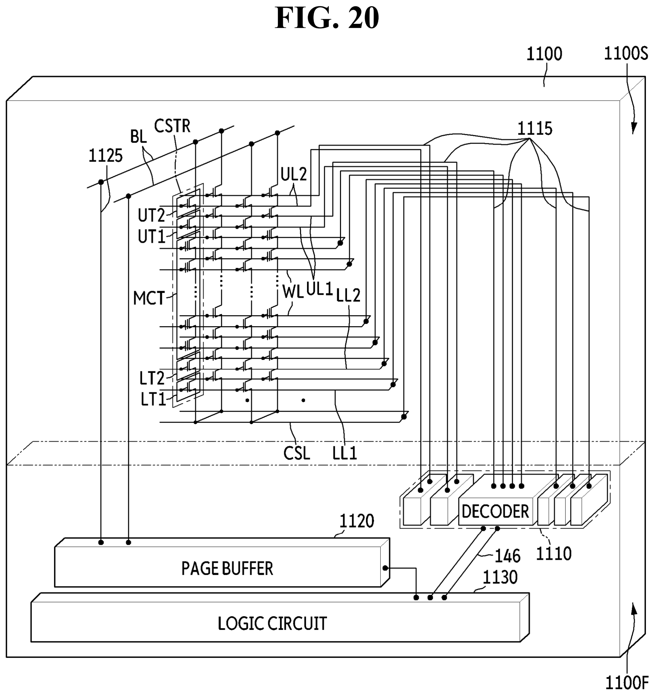

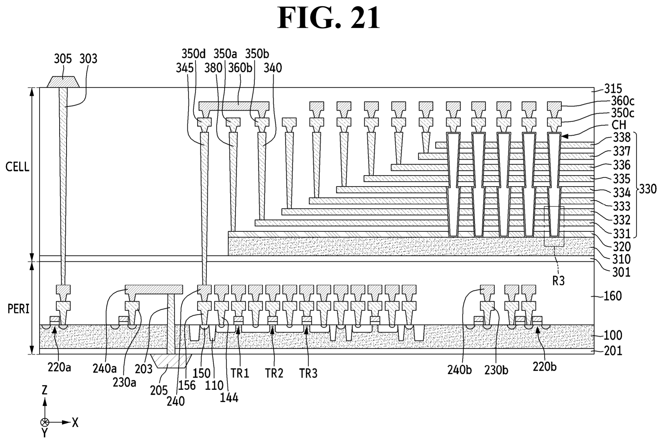

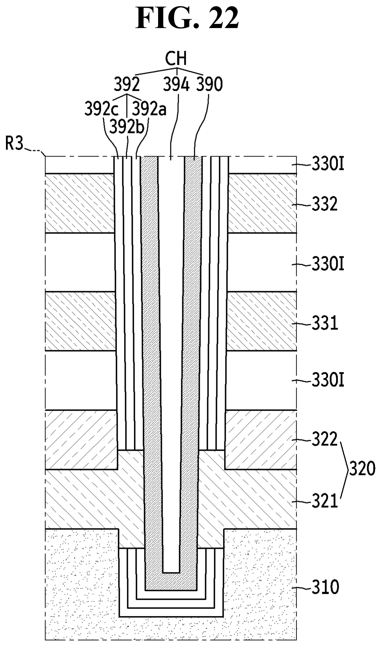

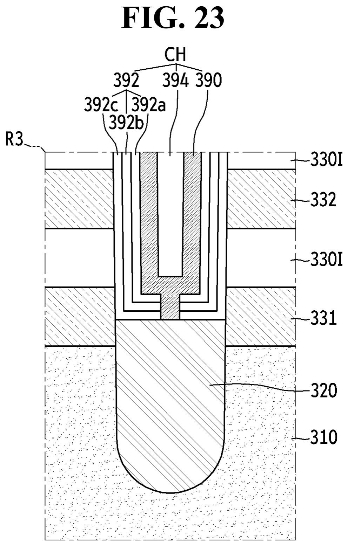

FIG. 20 is a schematic block diagram for illustrating a nonvolatile memory device according to some embodiments of the present disclosure. FIG. 21 is a schematic cross-sectional diagram for illustrating a nonvolatile memory device according to some embodiments of the present disclosure. FIGS. 22 and 23 are various enlarged views for illustrating a R3 area of FIG. 21. For convenience of description, features which duplicate the features which have been described above with reference to FIGS. 1 to 19 will be briefly described or descriptions thereof are omitted.

Referring to FIG. 20, the nonvolatile memory device according to some embodiments may include a first structure 1100F and a second structure 1100S disposed on the first structure 1100F.

In some embodiments, the first structure 1100F may be positioned next to the second structure 1100S. The first structure 1100F may be a peripheral circuit structure including a decoder circuit 1110, a page buffer 1120, and a logic circuit 1130. The second structure 1100S may be a memory cell structure including a bit-line BL, a common source line CSL, word-lines WL, first and second gate upper lines UL1 and UL2, first and second gate lower lines LL1 and LL2, and memory cell strings CSTR between the bit-line BL and the common source line CSL.

In the second structure 1100S, each memory cell string CSTR may include lower transistors LT1 and LT2 adjacent to the common source line CSL, upper transistors UT1 and UT2 adjacent to the bit-line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may vary depending on embodiments.

In some embodiments of the present disclosure, the upper transistors UT1 and UT2 may include a string select transistor, and the lower transistors LT1 and LT2 may include a ground select transistor. The first and second gate lower lines LL1 and LL2 may be gate electrodes of the lower transistors LT1 and LT2, respectively. The word-lines WL may be gate electrodes of memory cell transistors MCT, respectively. The first and second gate upper lines UL1 and UL2 may be gate electrodes of upper transistors UT1 and UT2, respectively.

In some embodiments of the present disclosure, the lower transistors LT1 and LT2 may include a lower erase control transistor LT1 and a ground select transistor LT2 connected to each other in a series manner. The upper transistors UT1 and UT2 may include a string select transistor UT1 and an upper erase control transistor UT2 connected to each other in a series manner. At least one of the lower erase control transistor LT1 and the upper erase control transistor UT2 may be used for an erase operation of erasing data stored in the memory cell transistors MCT using a gate induced drain leakage (GIDL) phenomenon.

The common source line CSL, the first and second gate lower lines LL1 and LL2, the word-lines WL, and the first and second gate upper lines UL1 and UL2 may be electrically connected to the decoder circuit 1110 via first connection wirings 1115 that extend from the first structure 1100F to the second structure 1100S. The bit-lines BL may be electrically connected to the page buffer 1120 via second connection wirings 1125 that extend from the first structure 1100F to the second structure 1100S.

In the first structure 1100F, the decoder circuit 1110 and the page buffer 1120 may perform a control operation on at least one select memory cell transistor among the plurality of memory cell transistors MCT. The decoder circuit 1110 and the page buffer 1120 may be controlled by the logic circuit 1130.

Referring to FIG. 21, a nonvolatile memory device according to some embodiments may include a peripheral circuit area PERI and a cell area CELL.

The peripheral circuit area PERI may include the first substrate 100, the interlayer insulating film 160, a plurality of circuit elements TR1, TR2, TR3, 220a, 220b formed on the first substrate 100, a first metal layer 144, 156, 230a, and 230b connected to each of the plurality of circuit elements TR1, TR2, TR3, 220a, and 220b, and a second metal layer 240, 240a, and 240b formed on the first metal layer 144, 156, 230a, and 230b.

In some embodiments, the first to third circuit elements TR1, TR2, and TR3 may provide a decoder circuit (e.g., 1110 of FIG. 20) in the peripheral circuit area PERI. In some embodiments, the fourth circuit element 220a may provide a logic circuit (e.g., 1130 of FIG. 20) in the peripheral circuit area PERI. In some embodiments, the fifth circuit element 220b may provide a page buffer (e.g., 1120 of FIG. 20) in the peripheral circuit area PERI.

Herein, only the first metal layer 144, 156, 230a, and 230b and the second metal layer 240, 240a, and 240b are illustrated and described. However, embodiments of the present disclosure are not limited thereto, and at least one more metal layer may be further formed on the second metal layer 240, 240a, and 240b. At least some of one or more metal layers formed on top of the second metal layer 240, 240a, and 240b may be made of aluminum or the like having a lower resistance than that of the copper constituting the second metal layer 240, 240a, and 240b.

In some embodiments, the first metal layer 144, 156, 230a, and 230b may be made of tungsten having a relatively high resistance, and the second metal layer 240, 240a, and 240b may be made of copper having a relatively low resistance.

The interlayer insulating film 160 may be disposed on the first substrate 100 so as to cover the plurality of circuit elements TR1, TR2, TR3, 220a, and 220b, the first metal layer 144, 156, 230a, and 230b, and the second metal layer 240, 240a, and 240b.

The cell area CELL may provide at least one memory block. The cell area CELL may include a second substrate 310 and a common source line 320. On the second substrate 310, a plurality of word-lines 331 to 338, collectively identified by reference numeral 330, may be stacked along a vertical direction Z intersecting an upper surface of the second substrate 310, for example wherein the vertical direction Z is not parallel to the upper surface of the second substrate 310. A string select line (e.g., UL1 and UL2 in FIG. 20) and a ground select line (e.g., LL1 and LL2 in FIG. 20) may be respectively disposed on top of and under the word-lines 330, and a plurality of word-lines 330 may be disposed between the string select lines and the ground select line.

A channel structure CH may extend in the vertical direction Z so as to extend through the word-lines 330, the string select lines, and the ground select line. As illustrated in FIG. 22 and FIG. 23, the channel structure CH may include a semiconductor pattern 390 and an information storage film 392.

The semiconductor pattern 390 may extend in the third direction Z. The semiconductor pattern 390 is illustrated as having a cup shape. However, this is only an example, and the semiconductor pattern 390 may have various shapes such as a circular cylindrical shape, a square cylindrical shape, a solid filler shape, etc. The semiconductor pattern 390 may include, but is not limited to, a semiconductor material such as single crystal silicon, polycrystalline silicon, an organic semiconductor material, and carbon nanostructures.

The information storage film 392 may be interposed between the semiconductor pattern 390 and the word-lines 330. For example, the information storage film 392 may extend along a side surface of the semiconductor pattern 390.

In some embodiments, the information storage film 392 may be formed as a stack of a multi films. For example, the information storage film 392 may include a tunnel insulating film 392a, a charge storage film 392b, and a blocking insulating film 392c sequentially stacked on the semiconductor pattern 390. The tunnel insulating film 392a may include, for example, silicon oxide or a high-k material having a higher dielectric constant than that of silicon oxide. The high-k material may include, for example, aluminum oxide (Al₂O₃), or hafnium oxide (HfO₂). The charge storage film 392b may include, for example, silicon nitride. The blocking insulating film 392c may include, for example, silicon oxide or a high-k material having a higher dielectric constant than that of silicon oxide.

In some embodiments, the channel structure CH may further include a filling pattern 394. The filling pattern 394 may be formed to fill an inside of the semiconductor pattern 390 having a cup shape. The filling pattern 394 may include, but is not limited to, an insulating material, such as silicon oxide.

The common source line 320 may be formed to contact the semiconductor pattern 390 of the channel structure CH.

As illustrated in FIG. 22, in some embodiments, the channel structure CH may extend through the common source line 320 so as to be partially embedded in the second substrate 310. The common source line 320 may extend through a portion of the information storage film 392 so as to be in contact with a side surface of the semiconductor pattern 390. The common source line 320 may include a source layer 321 and a source support layer 322.

As illustrated in FIG. 23, in some embodiments, at least a portion of the common source line 320 may be embedded in the second substrate 310. The common source line 320 may be formed, for example, in a selective epitaxial growth (SEG) process from the second substrate 310. The channel structure CH may extend through a portion of the information storage film 392 so as to be in contact with an upper surface of the common source line 320.

Referring back to FIG. 21, the channel structure CH may be electrically connected to a first metal layer 350c and a second metal layer 360c. For example, the first metal layer 350c may be a bit-line contact, and the second metal layer 360c may be a bit-line (e.g., BL of FIG. 20). In some embodiments, the bit-line 360c may extend along a direction parallel to the upper surface of the second substrate 310 (e.g., the second direction Y). In some embodiments, the bit-line 360c may be electrically connected to a fifth circuit element 220b that provides the page buffer (e.g., 1120 of FIG. 20) in the peripheral circuit area PERI.

The word-lines 330 may extend along a direction parallel to the upper surface of the second substrate 310 (e.g., the first direction X) and may be connected to a plurality of cell contact plugs 340. The word-lines WL and the cell contact plugs 340 may be connected to each other via pads formed by extending at least some of the word-lines WL by different lengths. A first metal layer 350b and a second metal layer 360b may be sequentially stacked on the cell contact plugs 340 connected to the word-lines 330 and may be connected to tops of the cell contact plugs 340.

In some embodiments of the present disclosure, the cell contact plugs 340 may be electrically connected to the first to third circuit elements TR1, TR2, and TR3 that provide a decoder circuit (e.g., 1110 of FIG. 20) in the peripheral circuit area PERI. In one example, the first metal layer 350b connected to the cell contact plugs 340 may be connected to the first metal layer 350d via the second metal layer 360b. The first metal layer 350d may be connected to the second metal layer 240 via a connection contact plug 345. Accordingly, the first to third circuit elements TR1, TR2, and TR3 may be electrically connected to the word-lines 330. For example, the first circuit element TR1 may be electrically connected to some of the word-lines 330, the second circuit element TR2 may be electrically connected to others of the word-lines 330, and the third circuit element TR3 may be electrically connected to the others of the word-lines 330.

In some embodiments of the present disclosure, an operating voltage of each of the first to third circuit elements TR1, TR2, and TR3 may be different from an operating voltage of the fifth circuit element 220b providing the page buffer (e.g., 1120 of FIG. 20). In one example, the operating voltage of the fifth circuit element 220b may be greater than the operating voltage of each of the first to third circuit elements TR1, TR2, and TR3.

A common source line contact plug 380 may be electrically connected to the common source line 320. The common source line contact plug 380 may be made of a conductive material such as a metal, a metal compound, or polysilicon, and a first metal layer 350a may be formed on top of the common source line contact plug 380.

In some embodiments of the present disclosure, a lower insulating film 201 covering a lower surface of the first substrate 100 may be formed under the first substrate 100. A first input/output pad 205 may be formed on the lower insulating film 201. The first input/output pad 205 may be connected to at least one of the plurality of circuit elements TR1, TR2, TR3, 220a, and 220b disposed in the peripheral circuit area PERI via a first input/output contact plug 203, and may be isolated from the first substrate 100 via the lower insulating film 201. Furthermore, a side insulating film may be disposed between the first input/output contact plug 203 and the first substrate 100 so as to electrically insulate the first input/output contact plug 203 and the first substrate 100 from each other.

In some embodiments of the present disclosure, an upper insulating film 301 covering a lower surface of the second substrate 310 may be formed on the second substrate 310. An interlayer insulating film 315 may be formed on the upper insulating film 301 and the second substrate 310, and a second input/output pad 305 may be disposed on the interlayer insulating film 315. The second input/output pad 305 may be connected to at least one of the plurality of circuit elements TR1, TR2, TR3, 220a, and 220b disposed in the peripheral circuit area PERI via a second input/output contact plug 303.

In some embodiments of the present disclosure, in an area where the second input/output contact plug 303 is disposed, the second substrate 310 and the common source line 320 may not be disposed. Furthermore, the second input/output pad 305 may not overlap with the word-lines 330 in the vertical direction Z. For example, in a plan view parallel to an upper surface of the first substrate 100, there may be no alignment in the vertical direction Z between any portion of the second input/output pad 305 and any portion of the word-lines 330. The second input/output contact plug 303 may be isolated from the second substrate 310 in a direction parallel to the upper surface of the second substrate 310 (for example, the first direction X) and may extend through the interlayer insulating film 315 of the cell area CELL so as to be connected to the second input/output pad 305.

In some embodiments, the first input/output pad 205 and the second input/output pad 305 may be formed optionally. In one example, the nonvolatile memory device according to some embodiments may include only the first input/output pad 205 disposed on the first substrate 100, or may include only the second input/output pad 305 disposed on the second substrate 310. Alternatively, the nonvolatile memory device according to some embodiments may include both the first input/output pad 205 and the second input/output pad 305.

In some embodiments of the present disclosure, the second impurity area contact 156 may be electrically connected to the first input/output pad 205 or the second input/output pad 305 via the first input/output contact plug 203 or the second input/output contact plug 303. Accordingly, the voltage may be applied to the second impurity area contact 156.

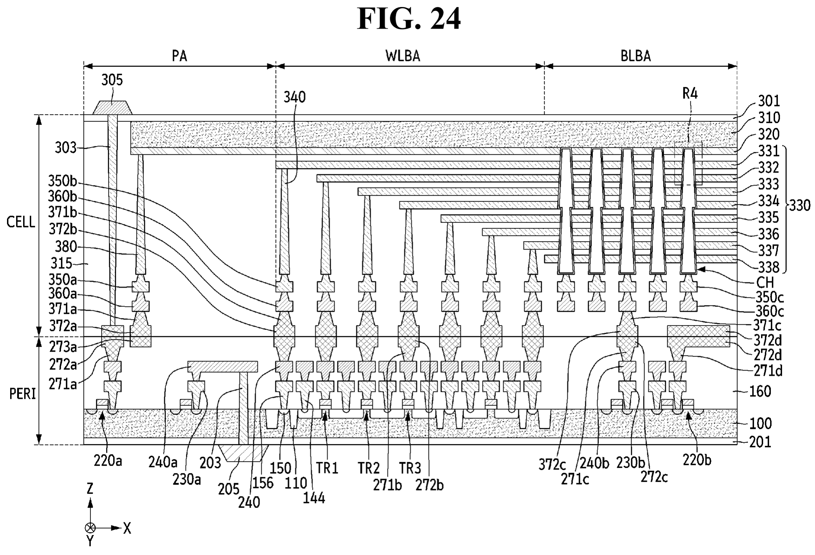

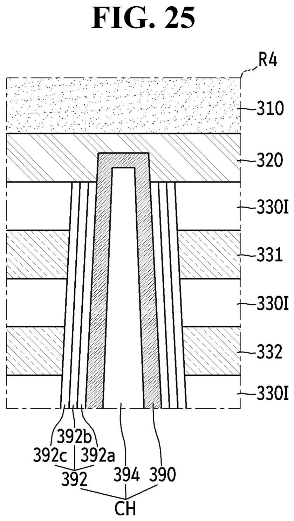

FIG. 24 is a schematic cross-sectional view for illustrating a semiconductor device according to some embodiments of the present disclosure. FIG. 25 is an enlarged view for illustrating an area R4 of FIG. 24. For convenience of description, features which duplicate the features described above using FIGS. 1 to 23 are briefly described or descriptions thereof are omitted.

Referring to FIG. 24, the nonvolatile memory device according to some embodiments may have a C2C (chip to chip) structure.

In this regard, the C2C structure may refer to a structure in which at least one upper chip including a memory cell area CELL is disposed on a first wafer and a lower chip including a peripheral circuit area PERI is disposed on a second wafer different from the first wafer, and then the upper chip and the lower chip are connected to each other in a bonding scheme. In one example, the bonding scheme means a scheme for electrically connecting a first bonding metal formed in an uppermost metal layer of the upper chip and a second bonding metal formed in an uppermost metal layer of the lower chip to each other. For example, when each of the first bonding metal and the second bonding metal is made of copper (Cu), the bonding scheme may be embodied as a Cu-Cu bonding scheme. However, this is merely an example. In another example, each of the first bonding metal and the second bonding metal may be made of various other metals such as aluminum (Al) or tungsten (W).

In some embodiments, each of the peripheral circuit area PERI and the cell area CELL may include an external pad bonding area PA, a word-line bonding area WLBA, and a bit-line bonding area BLBA.

The word-line bonding area WLBA may be defined as an area where a plurality of cell contact plugs 340, etc. are disposed. A lower bonding metal 271b and 272b may be formed on a second metal layer 240 of the word-line bonding area WLBA. In the word-line bonding area WLBA, the lower bonding metal 271b and 272b of the peripheral circuit area PERI may be electrically connected to an upper bonding metal 371b and 372b of the cell area CELL in a bonding manner. Each of the lower bonding metal 271b and 272b and the upper bonding metal 371b and 372b may be made of aluminum, copper, or tungsten. In the word-line bonding area WLBA, the cell contact plugs 340 may be connected to the peripheral circuit area PERI via the upper bonding metal 371b and 372b of the cell area CELL and the lower bonding metal 271b and 272b of the peripheral circuit area PERI.

The bit-line bonding area BLBA may be defined as an area where a channel structure CH and a bit-line 360c are disposed. The bit-line 360c may be electrically connected to a fifth circuit element 220b in the bit-line bonding area BLBA. For example, the bit-line 360c may be connected to the upper bonding metal 371c and 372c in the cell area CELL. The upper bonding metal 371c and 372c may be connected to the lower bonding metal 271c and 272c connected to the fifth circuit element 220b in the peripheral circuit area PERI.

A common source line contact plug 380 may be disposed in the external pad bonding area PA. The common source line contact plug 380 may be made of a conductive material such as metal, metal compound, or polysilicon, and may be electrically connected to a common source line 320. A first metal layer 350a and a second metal layer 360a may be disposed on top of the common source line contact plug 380 and may be sequentially stacked. For example, an area where the common source line contact plug 380, the first metal layer 350a, and the second metal layer 360a are disposed may be defined as the external pad bonding area PA. Furthermore, input/output pads 205 and 305 may be disposed in the external pad bonding area PA.

A metal pattern of the uppermost metal layer in each of the external pad bonding area PA and the bit-line bonding area BLBA included in the cell area CELL and peripheral circuit area PERI, respectively may exist as a dummy pattern. Alternatively, the uppermost metal layer in each of the external pad bonding area PA and the bit-line bonding area BLBA included in the cell area CELL and peripheral circuit area PERI, respectively may be empty.

In the non-volatile memory device according to some embodiments, in the external pad bonding area PA, a lower metal pattern 273a of the same shape as that of an upper metal pattern 372a of the cell area CELL may be formed in the uppermost metal layer of the peripheral circuit area PERI in a corresponding manner to the upper metal pattern 372a formed in the uppermost metal layer of the cell area CELL. The lower metal pattern 273a formed in the uppermost metal layer of the peripheral circuit area PERI may not be connected to a separate contact in the peripheral circuit area PERI. Similarly, in the external pad bonding area PA, an upper metal pattern of the same shape as that of a lower metal pattern of the peripheral circuit area PERI may be formed in the upper metal layer of the cell area CELL in a corresponding manner to the lower metal pattern formed in the uppermost metal layer of the peripheral circuit area PERI.

Furthermore, in the bit-line bonding area BLBA, an upper metal pattern 372d of the same shape as that of a lower metal pattern 272d of the peripheral circuit area PERI may be formed in the uppermost metal layer of the cell area CELL in a corresponding manner to the lower metal pattern 272d formed in the uppermost metal layer of the peripheral circuit area PERI. A contact may not be formed on the upper metal pattern 372d formed in the uppermost metal layer of the cell area CELL.

Hereinafter, with reference to FIGS. 1 to 33, a method for manufacturing a semiconductor device according to some embodiments will be described.

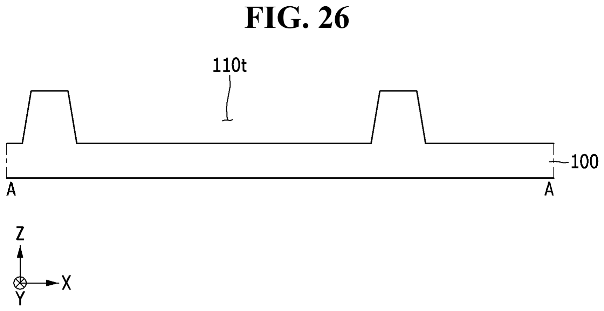

FIGS. 26 to 33 are diagrams of intermediate structures corresponding to intermediate steps of a method for manufacturing a semiconductor device according to some embodiments of the present disclosure. For the convenience of the description, features which duplicate the features described using FIGS. 1 to 19 will be briefly described or descriptions thereof are omitted.

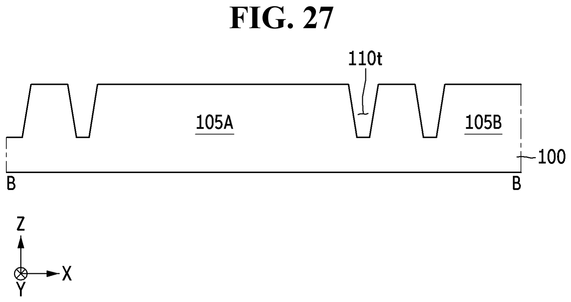

Referring to FIG. 26 and FIG. 27, the element isolation film trench 110t may be formed in the first substrate 100.

Specifically, the first active area 105A and the second active area 105B may be defined by the element isolation film trench 110t.

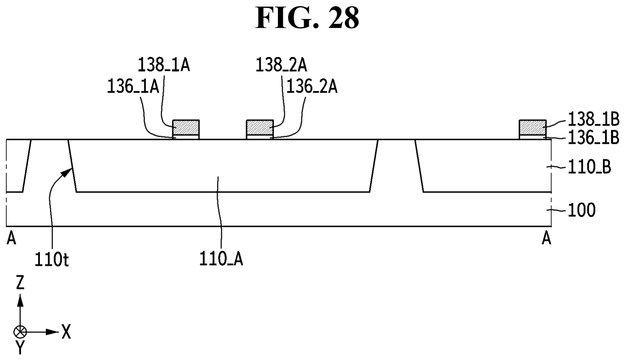

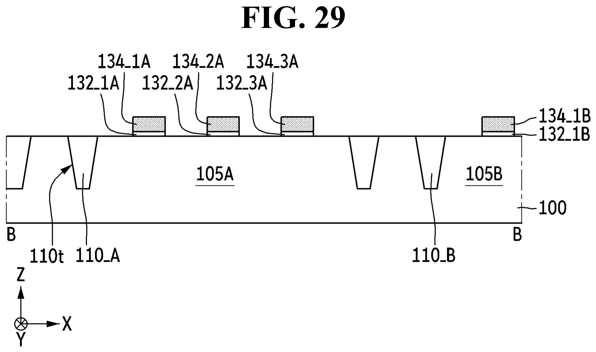

Referring to FIG. 28 and FIG. 29, the element isolation films 110_A and 110_B may fill the element isolation film trench 110t.

Next, the first and second auxiliary dielectric films 136_1A, 136_2A, and 136_1B and the first and second auxiliary electrodes 138_1A, 138_2A, and 138_1B may be sequentially formed on the element isolation films 110_A and 110_B. At the same level, the first to third gate dielectric films 132_1A, 132_2A, 132_3A, 132_1B and the first to third gate electrodes 134_1A, 134_2A, 134_3A, and 134_1B may be sequentially formed on the first and second active areas 105A and 105B.

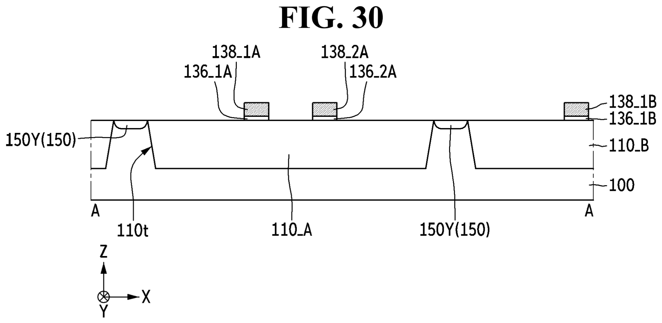

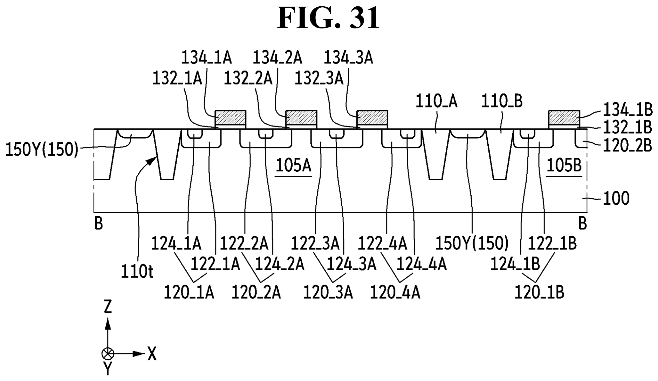

Referring to FIG. 30 and FIG. 31, the impurity area 150 may be formed between the element isolation films 110_A and 110_B, and the first to fourth source/drain areas 120_1A, 120_2A, 120_3A, 120_4A, 120_1B, and 120_2B may be formed between the element isolation films 110_A and 110_B and the first to third gate electrodes 134_1A, 134_2A, 134_3A, and 134_1B.

Specifically, the impurity area 150 and the first to fourth source/drain areas 120_1A, 120_2A, 120_3A, 120_4A, 120_1B, and 120_2B may be formed at the same level. However, embodiments of the present disclosure are not limited thereto. For example, the impurity area 150 may be formed first, and the first to fourth source/drain areas 120_1A, 120_2A, 120_3A, 120_4A, 120_1B, and 120_2B may be formed next. The impurity area 150 and the first to fourth source/drain areas 120_1A, 120_2A, 120_3A, 120_4A, 120_1B, and 120_2B may be doped with the same conductivity type impurity. For example, the impurity area 150 and the first to fourth source/drain areas 120_1A, 120_2A, 120_3A, 120_4A, 120_1B, and 120_2B may be doped with the n-type impurity.

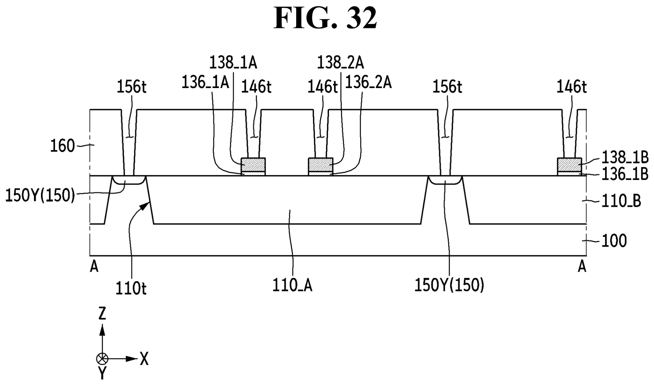

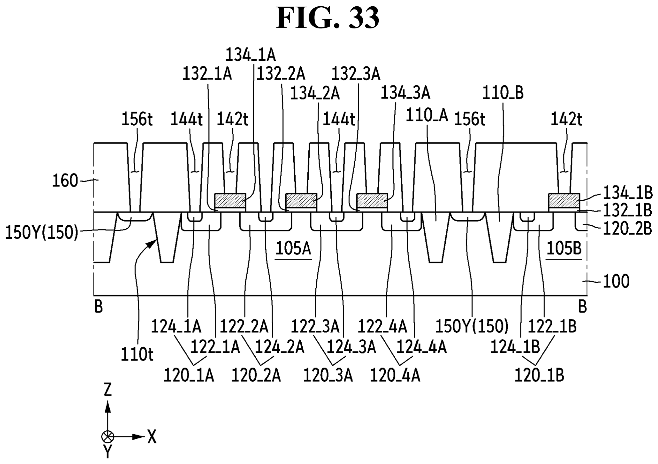

Referring to FIG. 32 and FIG. 33, the interlayer insulating film 160 may cover the element isolation films 110_A and 110_B, the first substrate 100, the first to third gate electrodes 134_1A, 134_2A, 134_3A, and 134_1B, and the first and second auxiliary electrodes 138_1A, 138_2A, and 138_1B.

Subsequently, a gate contact hole 142t, a source/drain contact hole 144t, an auxiliary electrode contact hole 146t, and a second impurity area contact hole 156t may be formed. The gate contact hole 142t, the source/drain contact hole 144t, the auxiliary electrode contact hole 146t, and the second impurity area contact hole 156t may extend through the interlayer insulating film 160 in the third direction Z.

Next, referring to FIGS. 1 to 3, the gate contact hole 142t, the source/drain contact hole 144t, the auxiliary electrode contact hole 146t, and the second impurity area contact hole 156t may be filled with a conductive material, so that the gate contact 142, the source/drain contact 144, the auxiliary electrode contact 146, and the second impurity area contact 156 may be formed. Thus, the semiconductor device according to some embodiments of the present disclosure described above using FIGS. 1 to 6 may be manufactured.

Hereinafter, an electronic system according to some embodiments of the present disclosure will be described with reference to FIGS. 1 to 37.

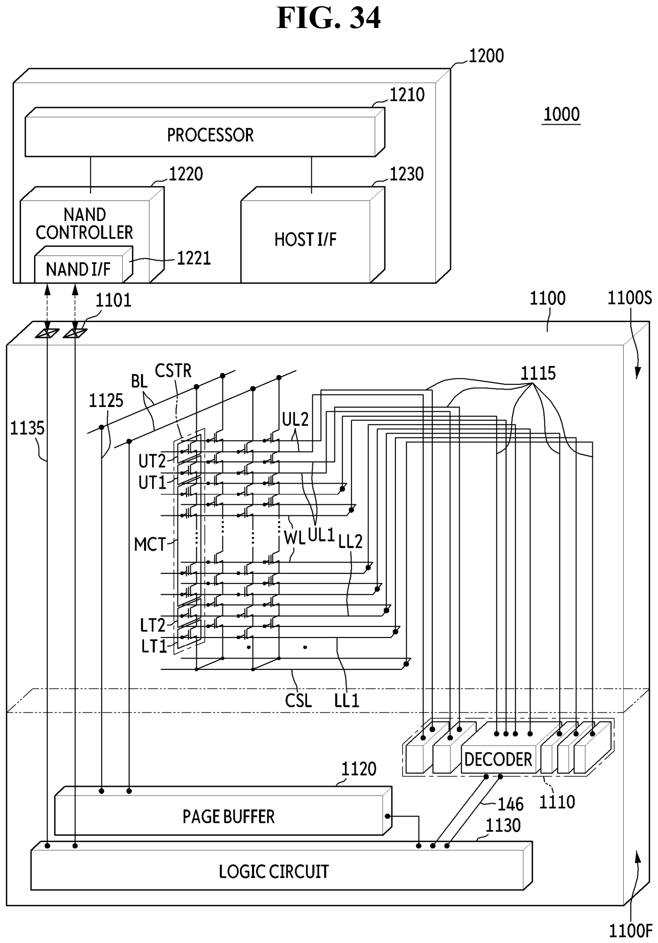

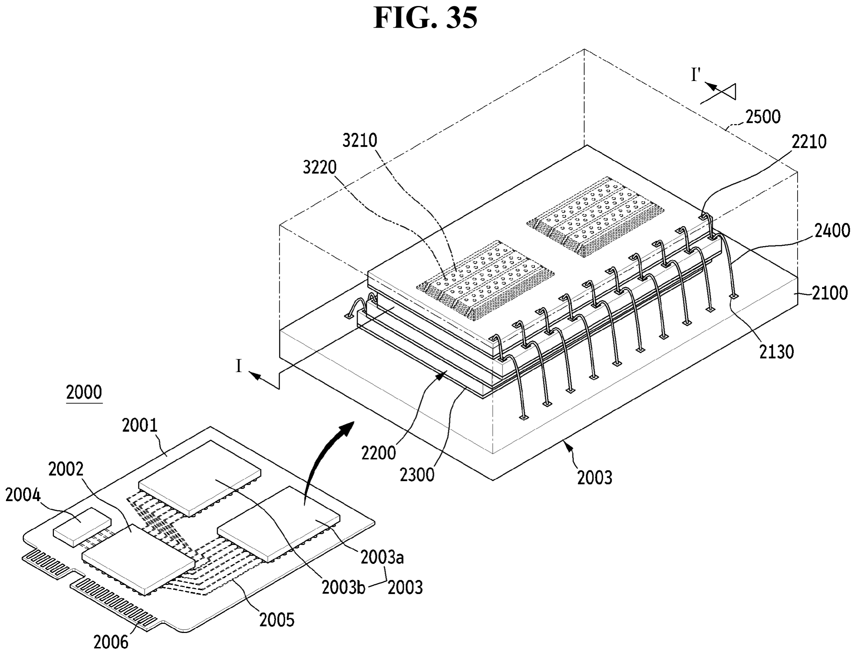

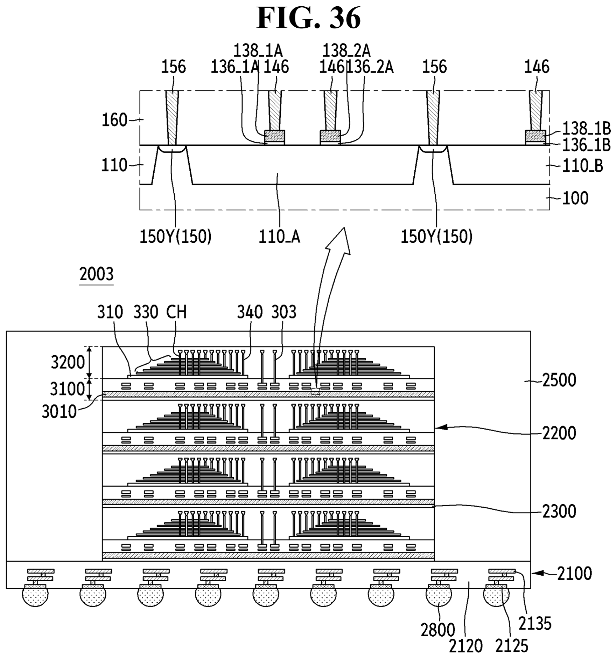

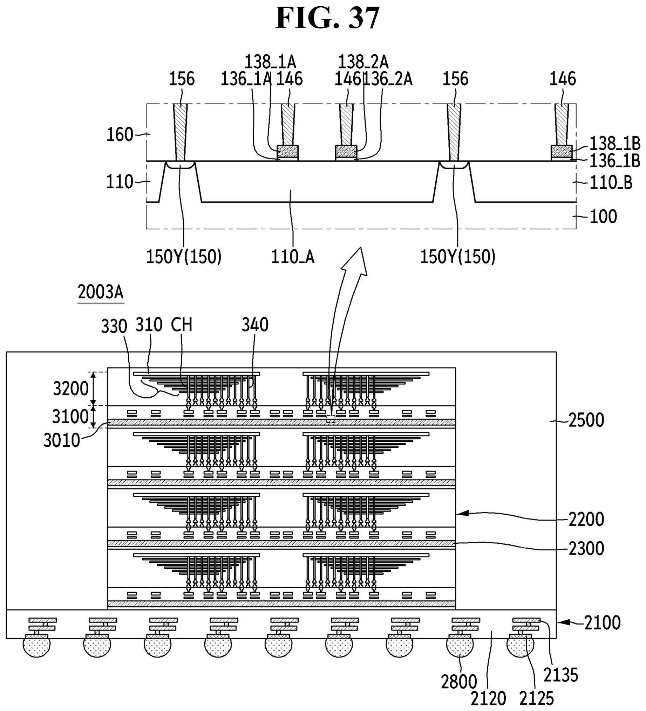

FIG. 34 is an example block diagram for illustrating an electronic system according to some embodiments of the present disclosure. FIG. 35 is an example perspective view for illustrating an electronic system according to some embodiments of the present disclosure. FIG. 36 and FIG. 37 are various schematic cross-sectional views taken along a line I-I' of FIG. 35. For convenience of description, features which duplicate the features described above using FIGS. 1 to 33 are briefly described or descriptions thereof are omitted.

Referring to FIG. 34, an electronic system 1000 according to some embodiments may include a semiconductor device 1100 and a controller 1200 electrically connected to the semiconductor device 1100. The electronic system 1000 may be a storage device including one or a plurality of semiconductor devices 1100 or an electronic device including the storage device. For example, the electronic system 1000 may be a solid state drive device (SSD), a Universal Serial Bus (USB), a computing system, a medical device, or a communication device including one or a plurality of semiconductor devices 1100.

The semiconductor device 1100 may be a nonvolatile memory device (e.g., a NAND flash memory device), and may be, for example, a nonvolatile memory device described above using FIG. 20 to FIG. 24. The semiconductor device 1100 may communicate with the controller 1200 through an input/output pad 1101 that is electrically connected to the logic circuit 1130. The input/output pad 1101 may be electrically connected to the logic circuit 1130 via an input/output connection wiring 1135 that extends from the first structure 1100F to the second structure 1100S.

The controller 1200 may include a processor 1210, a NAND controller 1220, and a host interface 1230. In some embodiments, the electronic system 1000 may include a plurality of semiconductor devices 1100. In this case, the controller 1200 may control the plurality of semiconductor devices 1100.

The processor 1210 may control the overall operations of the electronic system 1000 including the controller 1200. The processor 1210 may operate according to desired and/or alternatively predetermined firmware and may control the NAND controller 1220 to access the semiconductor device 1100. The NAND controller 1220 may include a NAND interface 1221 that deals with communication with the semiconductor device 1100. Through the NAND interface 1221, a control command for controlling the semiconductor device 1100, data to be written to the memory cell transistors MCT of the semiconductor device 1100, data to be read from the memory cell transistors MCT of the semiconductor device 1100, etc. may be transmitted. The host interface 1230 may provide a communication function between the electronic system 1000 and an external host. When the control command is received from the external host via the host interface 1230, the processor 1210 may control the semiconductor device 1100 in response to the control command.

Referring to FIG. 35, an electronic system according to some embodiments may include a main substrate 2001 (e.g., main board), a main controller 2002 mounted on the main substrate 2001, one or more semiconductor packages 2003, and a DRAM 2004. The semiconductor package 2003 and the DRAM 2004 may be connected to the main controller 2002 via line patterns 2005 formed on the main substrate 2001.

The main substrate 2001 may include a connector 2006 including a plurality of pins coupled to an external host. The number and an arrangement of the plurality of pins in the connector 2006 may vary based on a communication interface between the electronic system 2000 and the external host. In some embodiments, the electronic system 2000 may communicate with the external host using one of interfaces such as USB (Universal Serial Bus), PCI-Express (Peripheral Component Interconnect Express), SATA (Serial Advanced Technology Attachment), M-Phy for UFS (Universal Flash Storage), etc. In some embodiments, the electronic system 2000 may operate using power supplied from the external host via the connector 2006. The electronic system 2000 may further include a power management integrated circuit (PMIC) for distributing power supplied from the external host to the main controller 2002 and the semiconductor package 2003.

The main controller 2002 may write data to the semiconductor package 2003 or read data from the semiconductor package 2003, and may improve an operating speed of the electronic system 2000.

The DRAM 2004 may act as a buffer memory for reducing a difference between operation speeds of the semiconductor package 2003 as a data storage space and the external host. The DRAM 2004 included in electronic system 2000 may operate as a cache memory, and may provide a space for temporarily storing data therein in a control operation of the semiconductor package 2003. When the DRAM 2004 is included in the electronic system 2000, the main controller 2002 may further include a DRAM controller for controlling the DRAM 2004 in addition to a NAND controller for controlling the semiconductor package 2003.

The semiconductor package 2003 may include a first semiconductor package 2003a and a second semiconductor package 2003b spaced apart from each other. Each of the first semiconductor package 2003a and the second semiconductor package 2003b may be embodied as a semiconductor package including a plurality of semiconductor chips 2200. Each of the first semiconductor package 2003a and the second semiconductor package 2003b may include a package substrate 2100, semiconductor chips 2200 on the package substrate 2100, adhesive layers 2300 disposed on a bottom face of each of the semiconductor chips 2200, a connection structure 2400 electrically connecting the semiconductor chips 2200 and the package substrate 2100 to each other, and a molding layer 2500 disposed on the package substrate 2100 and covering the semiconductor chips 2200 and the connection structure 2400.

The package substrate 2100 may be embodied as a printed circuit board including package upper pads 2130. Each semiconductor chip 2200 may include an input/output pad 2210. The input/output pad 2210 may correspond to the input/output pad 1101 in FIG. 34. Each of the semiconductor chips 2200 may include memory blocks 3210 and channel structures 3220. The memory blocks 3210 may correspond to the memory blocks of FIG. 21, and the channel structure 3220 may correspond to the channel structure CH of FIG. 21. Each of the semiconductor chips 2200 may include the non-volatile memory device described above using FIGS. 20 to 24.

In some embodiments, the connection structure 2400 may be embodied as a bonding wire that electrically connects the input/output pad 2210 and the package upper pads 2130 to each other. Accordingly, in each of the first semiconductor package 2003a and the second semiconductor package 2003b, the semiconductor chips 2200 may be electrically connected to each other in a bonding wire scheme, and may be electrically connected to the package upper pads 2130 of the package substrate 2100. In some embodiments, in each of the first semiconductor package 2003a and the second semiconductor package 2003b, the semiconductor chips 2200 may be electrically connected to each other via a connection structure including a through electrode (Through Silicon Via: TSV) instead of the connection structure 2400 using the bonding wire scheme.

In some embodiments, the main controller 2002 and the semiconductor chips 2200 may be included in one package. In some embodiments, the main controller 2002 and the semiconductor chips 2200 may be mounted on a separate interposer substrate different from the main substrate 2001, and the main controller 2002 and the semiconductor chips 2200 may be connected to each other via a line formed in the interposer substrate.

Referring to FIG. 36, in the semiconductor package 2003, the package substrate 2100 may be a printed circuit board. The package substrate 2100 may include a package substrate body 2120, package upper pads 2130 in FIG. 35 disposed on an upper surface of the package substrate body 2120, lower pads 2125 disposed on a lower surface of the package substrate body 2120 or exposed through the lower surface, and internal wirings 2135 disposed within the package substrate body 2120 so as to electrically connect the package upper pads 2130 and the lower pads 2125 to each other. The package upper pads 2130 may be electrically connected to the connection structures 2400. The lower pads 2125 may be connected to the line patterns 2005 (e.g., wiring patterns) of the main substrate 2010 of the electronic system 2000 via conductive connection portions 2800, as shown in FIG. 35.

Each of the semiconductor chips 2200 may include a semiconductor substrate 3010 and a first structure 3100 and a second structure 3200 sequentially stacked on the semiconductor substrate 3010. The semiconductor substrate 3010 may correspond to the first substrate 100 of FIG. 21. The first structure 3100 may correspond to the peripheral circuit area PERI of FIG. 21, and the second structure 3200 may correspond to the cell area CELL of FIG. 21.

For example, the second structure 3200 may include the second substrate 310, the plurality of word-lines 330, the channel structure CH, and the plurality of cell contact plugs 340. In some embodiments, as illustrated, the first structure 3100 may include the element isolation film 110 first and second auxiliary electrodes 138_1A, 138_2A, and 138_1B. Each of the semiconductor chips 2200 may further include the input/output pad 2210 of FIG. 35 electrically connected to the first structure 3100.

Referring to FIG. 37, in the semiconductor package 2003A, each of the semiconductor chips 2200 may include the first structure 3100 and the second structure 3200 bonded to each other in a wafer bonding scheme. For example, the first structure 3100 may correspond to the peripheral circuit area PERI of FIG. 24, and the second structure 3200 may correspond to the cell area CELL of FIG. 24.

The semiconductor chips 2200 of FIG. 36 and FIG. 37 may be electrically connected to each other via bonding wire-type connecting structures 2400 of FIG. 35. However, in some embodiments, the semiconductor chips 2200 within a single semiconductor package, such as the semiconductor chips 2200 of FIG. 36 and FIG. 37, may be electrically connected to each other via connecting structures including through-silicon vias (TSVs).

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

Although embodiments of the present disclosure have been described with reference to the accompanying drawings, the present disclosure is not limited to the above embodiments, and may be implemented in various different forms. A person skilled in the art may appreciate that the present disclosure may be practiced in other concrete forms without changing the characteristics of the present invention as defined according to the claims. Therefore, it should be appreciated that the embodiments as described above are not restrictive but illustrative in all respects.

## Claims

1. A semiconductor device comprising:
a substrate (100);
an element isolation film (110_A) on the substrate (100),
the element isolation film (110_A) defining a first active area (105A) of the substrate (100),
the first active area (105A) of the substrate (100) including a first source/drain area (120_1A) and a second source/drain area (120_2A) in the first active area (105A),
the first source/drain area (120_1A) contacting the element isolation film (110_A) in a first direction (X) and having a first conductivity type,
the second source/drain area (120_2A) being spaced apart from the first source/drain area (120_1A) in the first direction (X) and having the first conductivity type;
a first gate electrode (134_1A) on a portion of the first active area (105A) between the first source/drain area (120_1A) and the second source/drain area (120_2A), wherein the first gate electrode (134_1A) extends in a second direction (Y) and the second direction (Y) intersects the first direction (X);
a second gate electrode (134_2A) on the first active area (105A) and extending in the second direction (Y), wherein the second source/drain area (120_2A) is between the first gate electrode (134_1A) and the second gate electrode (134_2A); and
a first auxiliary electrode (138_1A) on the element isolation film (110_A),
wherein in a plan view, the first auxiliary electrode (138_1A) does not overlap the first source/drain area (120_1A) in the second direction (Y) and the first auxiliary electrode (138_1A) overlaps the second source/drain area (120_2A) in the second direction (Y).

2. The semiconductor device of claim 1, wherein a ground voltage is applied to the first auxiliary electrode (138_1A).

3. The semiconductor device of claim 1 or 2, wherein
the substrate (100) further includes an impurity area (150) in the substrate (100) and the impurity area (150) surrounds the element isolation film (110_A),
the impurity area (150) contains an impurity having a second conductivity type, and
the second conductivity type is different from the first conductivity type.

4. The semiconductor device of claim 3, wherein in the plan view,
the first auxiliary electrode (138_1A) is between the second source/drain area (120_2A) and the impurity area (150).

5. The semiconductor device of claim 3 or 4, further comprising:
a connection pattern (170) connecting the first auxiliary electrode (138_1A) and the impurity area (150) to each other,
wherein a ground voltage is applied to the impurity area (150).

6. The semiconductor device of any one of claims 3 to 5, wherein
the first conductivity type is an n-type, and
the second conductivity type is a p-type.

7. The semiconductor device of any preceding claim, wherein the first gate electrode (134_1A) and the first auxiliary electrode (138_1A) do not overlap each other in the first direction (X).

8. The semiconductor device of any preceding claim, wherein the first gate electrode (134_1A) and the first auxiliary electrode (138_1A) do not overlap each other in the second direction (Y).

9. The semiconductor device of any preceding claim, wherein the first gate electrode (134_1A) and the first auxiliary electrode (138_1A) are at a same level.

10. The semiconductor device of any preceding claim, wherein
the first active area (105A) of the substrate (100) further includes a third source/drain area (120_3A) in the first active area (105A),
the third source/drain area (120_3A) is in contact with the element isolation film (110_A) in the first direction (X) and the third source/drain area (120_3A) has the first conductivity type,
the second gate electrode (134_2A) is on a portion of the first active area (105A) between the second source/drain area (120_2A) and the third source/drain area (120_3A), and
in the plan view, the first auxiliary electrode (138_1A) does not overlap with the third source/drain area (120_3A) in the second direction (Y).

11. The semiconductor device of any one of claims 1 to 9, further comprising:
a third gate electrode (134_3A); and
a second auxiliary electrode (138_2A) on the element isolation film (110_A), wherein
the first active area (105A) of the substrate (100) further includes a third source/drain area (120_3A) and a fourth source/drain area (120_4A) in the first active area (105A),
the third source/drain area (120_3A) is spaced from the second source/drain area (120_2A) in the first direction (X), and the third source/drain area (120_3A) has the first conductivity type,
the fourth source/drain area (120_4A) is spaced from the third source/drain area (120_3A) in the first direction (X),
the fourth source/drain area (120_4A) contacts the element isolation film (110_A) in the first direction (X), and the fourth source/drain area (120_4A) has the first conductivity type,
the third gate electrode (134_3A) is on a portion of the first active area (105A) between the third source/drain area (120_3A) and the fourth source/drain area (120_4A),
the third gate electrode (134_3A) extends in the second direction (Y), and
in the plan view, the second auxiliary electrode (138_2A) overlaps the third source/drain area (120_3A) in the second direction (Y) and does not overlap the fourth source/drain area (120_4A) in the second direction (Y).

12. The semiconductor device of claim 11, wherein the second auxiliary electrode (138_2A) is spaced apart from the first auxiliary electrode (138_1A) in the first direction (X).

13. A semiconductor device comprising:
a substrate (100);
an element isolation film (110_A) on the substrate (100),
the element isolation film (110_A) defining a first active area (105A) of the substrate (100),
the first active area (105A) of the substrate (100) including a first source/drain area (120_1A) and a second source/drain area (120_2A) in the first active area (105A),
the first source/drain area (120_1A) having a first conductivity type,
the second source/drain area (120_2A) being spaced apart from the first source/drain area (120_1A) in a first direction (X) and having the first conductivity type;
a first gate electrode (134_1A) on a portion of the first active area (105A) between the first source/drain area (120_1A) and the second source/drain area (120_2A), wherein the first gate electrode (134_1A) extends in a second direction (Y) and the second direction (Y) intersects the first direction (X);
an auxiliary electrode (138_1A) on the element isolation film (110_A), wherein
the substrate (100) includes an impurity area (150) surrounding the element isolation film (110_A),
the impurity area (150) contains an impurity having a second conductivity type,
the second conductivity type is different from the first conductivity type, and
the auxiliary electrode (138_1A) and the impurity area (150) are electrically connected to each other.

14. The semiconductor device of claim 13, wherein a ground voltage is applied to the auxiliary electrode (138_1A) and the impurity area (150).

15. An electronic system comprising:
a main substrate (2001);
a semiconductor device (2200) on the main substrate (2001), the semiconductor device (2200) including a first substrate (3010, 100) having a peripheral circuit area (3100, PERI), and a second substrate (310) having a cell area (3200, CELL); and
a main controller (2002) on the main substrate (2001) and electrically connected to the semiconductor device (2200), wherein
the semiconductor device (2200) comprises an element isolation film (110_A) on the first substrate (100), a first gate electrode (134_1A), a second gate electrode (134_2A), an auxiliary electrode (138_1A) on the element isolation film (110_A), a plurality of word-lines (330) sequentially stacked on the second substrate (310), and a channel structure (CH) on the second substrate (310) and intersecting the plurality of word-lines (330), and a bit-line (360c) contacting the channel structure (CH),
the element isolation film (110_A) defines a first active area (105A) in the substrate (100),
the first active area (105A) includes a first source/drain area (120_1A) and a second source/drain area (120_2A)
the first source/drain area (120_1A) contacts the element isolation film (110_A) in a first direction (X) and has a first conductivity type,
the second source/drain area (120_2A) is spaced apart from the first source/drain area (120_1A) in the first direction (X) and has the first conductivity type,
the first gate electrode (134_1A) is on a portion of the first active area (105A) between the first source/drain area (120_1A) and the second source/drain area (120_2A),
the first gate electrode (134_1A) extends in a second direction (Y),
the second direction (Y) intersects the first direction (X),
the second gate electrode (134_2A) is on the first active area (105A) and extends in the second direction (Y),
the second source/drain area (120_2A) is between the first gate electrode (134_1A) and the second gate electrode (134_2A), and
in a plan view, the auxiliary electrode (138_1A) does not overlap the first source/drain area (120_1A) in the second direction (Y) and the auxiliary electrode (138_1A) overlaps the second source/drain area (120_2A) in the second direction (Y).
